(19) **Europäisches Patentamt / European Patent Office / Office européen des brevets**

(11) **EP 3 025 348 B1**

(12) **FASCICULE DE BREVET EUROPEEN**

(45) Date de publication et mention de la délivrance du brevet:
**10.05.2017 Bulletin 2017/19**

(21) Numéro de dépôt: **14739848.1**

(22) Date de dépôt: **18.07.2014**

(51) Int Cl.:
*G01R 33/12* *(2006.01)*          *H01L 43/02* *(2006.01)*
*H01L 43/08* *(2006.01)*          *H01L 43/10* *(2006.01)*
*H01F 10/32* *(2006.01)*          *G01R 33/09* *(2006.01)*
*G11C 11/16* *(2006.01)*          *G11C 11/15* *(2006.01)*

(86) Numéro de dépôt international:
**PCT/EP2014/065510**

(87) Numéro de publication internationale:
**WO 2015/011050 (29.01.2015 Gazette 2015/04)**

(54) **DISPOSITIF MAGNÉTIQUE CONTRÔLÉ EN TENSION ET FONCTIONNANT SUR UNE LARGE GAMME DE TEMPÉRATURE**

IN EINEM WEITEN TEMPERATURBEREICH BETREIBBARE SPANNUNGSGESTEUERTE MAGNETVORRICHTUNG

VOLTAGE-CONTROLLED MAGNETIC DEVICE OPERATING OVER A WIDE TEMPERATURE RANGE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.07.2013 FR 1357207**

(43) Date de publication de la demande:
**01.06.2016 Bulletin 2016/22**

(73) Titulaires:
• **Commissariat à l'Énergie Atomique et aux Énergies Alternatives**
**75015 Paris (FR)**
• **Centre National de la Recherche Scientifique (C.N.R.S.)**
**75794 Paris Cedex 16 (FR)**
• **Université Joseph Fourier - Grenoble**
**38041 Grenoble Cedex 9 (FR)**

(72) Inventeurs:
• **DIENY, Bernard**
**38250 Lans en Vercors (FR)**
• **BEA, Hélène**
**38500 Voiron (FR)**
• **BANDIERA, Sébastien**
**38700 Corenc (FR)**

(74) Mandataire: **Cabinet Camus Lebkiri**
**25 rue de Maubeuge**
**75009 Paris (FR)**

(56) Documents cités:
**US-A1- 2013 175 646**

• **YOICHI SHIOTA ET AL: "Induction of coherent magnetization switching in a few atomic layersof FeCo using voltage pulses", NATURE MATERIALS, vol. 11, 13 novembre 2011 (2011-11-13), pages 39-43, XP002724399, DOI: 10.1038/NMAT3172 cité dans la demande**
• **YANG ET AL: "First-principles investigation of the very large perpendicular magnetic anisotropy at Fe|MgO and Co|MgO interfaces", PHYSICAL REVIEW B, vol. 84, 054401, 1 août 2011 (2011-08-01), pages 054401-1-054401-5, XP002724400, DOI:10.1103/PhysRevB.84.054401 cité dans la demande**

**Description**

## DOMAINE TECHNIQUE DE L'INVENTION

La présente invention concerne un dispositif magnétique contrôlé en tension et fonctionnant sur une large gamme de température. Elle trouve notamment une application dans la réalisation de mémoire de type MRAM pour l'électronique grand public, l'électronique industrielle ou l'électronique militaire.

## ARRIERE-PLAN TECHNOLOGIQUE DE L'INVENTION

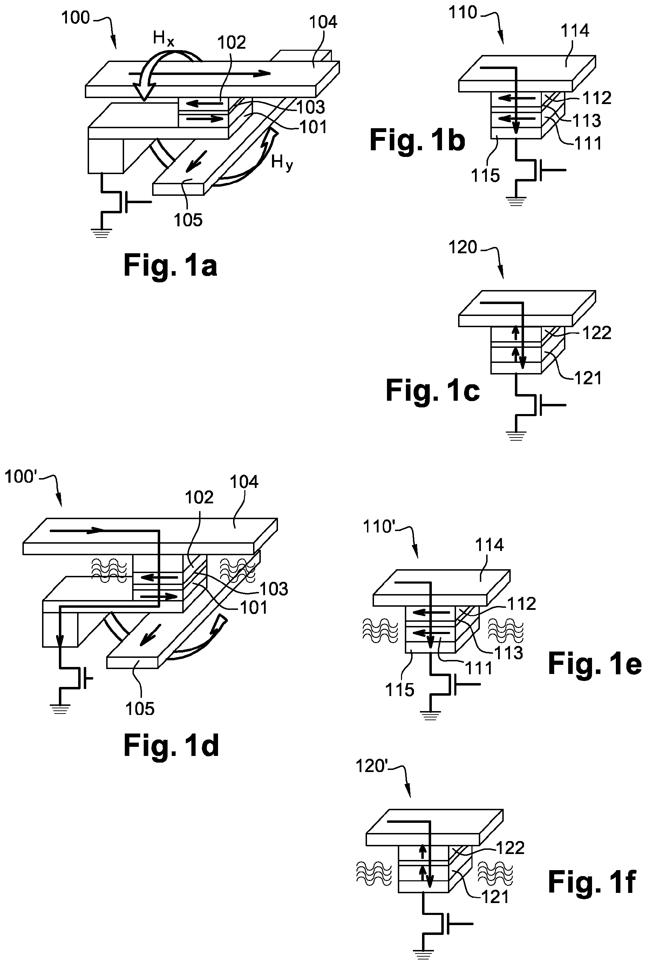

Afin de répondre aux continuels besoins d'augmentation de la densité pour l'électronique CMOS, la taille des dispositifs ne cesse de décroître. Cependant, ces dispositifs ont de plus en plus de problèmes de consommation d'énergie, notamment en mode statique, en raison d'un courant de fuite accru lié à leur diminution en taille.
Les mémoires non volatiles, qui conservent leurs données en l'absence d'alimentation, sont très intéressantes afin de diminuer la consommation d'énergie. Les mémoires magnétiques MRAM (« magnetic random access memory » en langue anglaise), qui sont à la fois non volatiles et capables d'assurer des temps de lecture et d'écriture rapides, sont donc particulièrement intéressantes. Ce type de mémoire est basé sur des jonctions tunnel magnétiques, formées par deux couches ferromagnétiques séparées par un oxyde isolant, généralement de l'oxyde de magnésium MgO. La résistance du dispositif varie typiquement d'un facteur 2 à 3 selon que l'aimantation des deux couches ferromagnétiques est parallèle ou antiparallèle, fournissant ainsi un « 0 » ou un « 1 » numérique. Dans un circuit électronique, la non-volatilité permet de réduire la consommation d'énergie en éteignant les parties temporairement inactives du circuit et donc en éliminant le courant de fuite dans ces parties. De nouvelles stratégies de déclenchement de l'alimentation sont ainsi rendues possibles. Le concept de calcul électronique dans un circuit normalement éteint avec mise en marche instantanée (« Normally-Off/Instant-On computing » en langue anglaise) a même été introduit pour décrire cette approche (« Challenges toward gigabit-scale spin-transfer torque random access memory and beyond for normally off, green information technology infrastructure », Takayuki Kawahara, J. Appl. Phys. 109, 07D325, 2011).
Cependant, les mécanismes d'écriture de ces dispositifs nécessitent toujours une quantité d'énergie relativement importante. La configuration la moins favorable est celle d'une écriture avec un champ magnétique induit par une circulation de courant dans une ligne conductrice située à proximité immédiate de la jonction tunnel magnétique (généralement au-dessus ou en-dessous). Dans ce cas, l'écriture nécessite des courants de l'ordre de quelques mA durant environ 10 ns. L'énergie associée à l'écriture d'un évènement est alors de plusieurs dizaines de pJ. Une cellule mémoire à écriture par champ magnétique 100 est représentée schématiquement à la figure 1a. La cellule mémoire à écriture par champ magnétique 100 est composée d'une première couche magnétique 101 et d'une deuxième couche magnétique 102, séparées par une couche d'oxyde 103 formant une barrière tunnel. L'aimantation de la première couche magnétique 101, dite couche de référence, est piégée dans une direction fixe. L'aimantation de la deuxième couche magnétique 102, dite couche de stockage, peut être orientée dans différentes directions par rapport à l'aimantation de la couche de référence 101. Une première ligne de courant 104 et une deuxième ligne de courant 105, situées au voisinage de la jonction tunnel magnétique et générant respectivement un premier champ magnétique Hx et un deuxième champ magnétique Hy, permettent de modifier l'aimantation de la couche de stockage 102.

L'utilisation du transfert de spin (« spin transfer torque » (STT) en langue anglaise) pour écrire dans une jonction tunnel magnétique fournit une meilleure configuration, en particulier lorsque la densité est importante, c'est-à-dire lorsque la mémoire est de petite taille (typiquement inférieure à 50 nm de diamètre). En effet, dans ce cas, la commutation est déterminée par une densité de courant. Ainsi, plus la jonction tunnel magnétique est petite, plus le courant requis pour écrire est faible, puisque le courant est égal à la densité de courant multipliée par l'aire de la jonction tunnel magnétique.

Actuellement, les jonctions tunnel magnétiques qui présentent une aimantation perpendiculaire au plan des couches (« perpendicular-to-plane magnetization » en langue anglaise) attirent beaucoup d'attention car elles nécessitent, pour une écriture donnée, une densité de courant très inférieure à celle requise par une jonction tunnel magnétique ayant une aimantation parallèle au plan des couches (« in-plane magnetization » en langue anglaise). Lors de l'écriture par transfert de spin, que l'on nommera « écriture STT » dans la suite de ce document, l'énergie d'écriture est de l'ordre de quelques pJ, ce qui reste très supérieur à l'énergie typiquement requise pour allumer et éteindre un transistor CMOS et qui est de l'ordre du fJ. Cette énergie d'écriture est principalement associée à la dissipation par effet Joule dans la jonction tunnel magnétique et dans les fils conducteurs connectés aux électrodes de la jonction tunnel magnétique. Une cellule mémoire magnétique à écriture par transfert de spin 110 avec une aimantation dans le plan des couches dite « IP » (de l'anglais « in-plane ») est représentée schématiquement à la figure 1 b. La cellule mémoire magnétique à écriture par transfert de spin 110 est composée d'une première couche magnétique 111 et d'une deuxième couche magnétique 112, séparées par une couche d'oxyde 113 formant une barrière tunnel. L'aimantation de la première couche magnétique 111, dite couche de référence, est piégée dans une direction fixe dans le plan des couches. L'aimantation de la deuxième couche magnétique 112, dite couche de stockage, peut être orientée dans différentes directions du plan des couches. Une première électrode 114 est placée au contact de la couche de stockage 112. Une deuxième électrode 115 est placée au contact de la couche de référence 111. Un courant polarisé en spin suffisamment important appliqué à travers la jonction tunnel magnétique au moyen des première et deuxième électrodes 114 et 115 permet d'exercer sur l'aimantation de la couche de stockage 112 un couple capable de la modifier.

Une cellule mémoire magnétique à écriture par transfert de spin 120 avec une aimantation hors du plan des couches dite « OP » (de l'anglais « out-of-plane ») est représentée schématiquement à la figure 1c. La cellule mémoire magnétique 120 diffère de la cellule mémoire magnétique 110 en ce que :

- l'aimantation de la couche de référence 121 est piégée dans une direction fixe hors du plan des couches ;
- l'aimantation de la couche de stockage 122 peut être orientée dans différentes directions hors du plan des couches.

Toutefois, un inconvénient de l'écriture STT est lié à la fiabilité de la barrière tunnel. En effet, la mémoire est traversée par une densité de courant relativement élevée, de l'ordre du MA/cm$^2$, à chaque écriture ce qui induit un risque de rupture diélectrique. La commutation thermiquement assistée (« thermally assisted switching » en langue anglaise), qui consiste à assister la commutation d'aimantation par un chauffage temporaire de la jonction tunnel magnétique, permet de faciliter la commutation au moment de l'écriture tout en assurant une très bonne stabilité de l'aimantation en régime hors écriture.

Une cellule mémoire à écriture par champ magnétique thermiquement assistée 100' est représentée schématiquement à la figure 1d. La cellule mémoire à écriture par champ magnétique thermiquement assistée 100' diffère de la cellule mémoire à écriture par champ magnétique 100 en ce qu'un courant est appliqué à travers la jonction tunnel magnétique, préalablement à la commutation d'aimantation de la couche de stockage 102, de manière à diminuer sensiblement le champ magnétique à appliquer à la jonction pour réaliser la commutation d'aimantation. Néanmoins, l'écriture par champ magnétique entraîne toujours une consommation électrique importante.

Une cellule mémoire magnétique à écriture par transfert de spin thermiquement assistée avec une aimantation «dans le plan » 110' est représentée schématiquement à la figure 1 e. La cellule mémoire à écriture par transfert de spin thermiquement assistée 110' diffère de la cellule mémoire magnétique à écriture par transfert de spin 110 en ce que le courant circulant à travers la jonction tunnel magnétique est utilisé à la fois pour réchauffer la couche de stockage de la cellule et pour exercer le couple STT permettant la commutation de l'aimantation de la couche de stockage 112, de manière à diminuer sensiblement le courant à appliquer à la jonction pour réaliser la commutation d'aimantation.

Une cellule mémoire magnétique à écriture par transfert de spin thermiquement assistée avec une aimantation hors du plan 120' est représentée schématiquement à la figure 1 f. La cellule mémoire à écriture par transfert de spin thermiquement assistée diffère de la cellule mémoire magnétique à écriture par transfert de spin 120 en ce que le courant circulant à travers la jonction tunnel magnétique est utilisé à la fois pour réchauffer la couche de stockage de la cellule et pour exercer le couple STT permettant la commutation de l'aimantation de la couche de stockage 122, de manière à diminuer sensiblement le courant à appliquer à la jonction pour réaliser la commutation d'aimantation. Cependant, ces deux derniers dispositifs posent encore des problèmes de fiabilité. Le document US20130175646 divulgue un circuit mémoire magnétique avec une couche magnétique auquel l'anisotropie vienne basculer par application de pression généré par la température d'une couche de stress.

Une nouvelle approche pour changer la résistance d'une jonction tunnel magnétique avec une aimantation perpendiculaire, c'est-à-dire pour changer la direction de l'aimantation, consiste à utiliser un champ électrique avec des courants extrêmement faibles traversant le dispositif. Une commutation rapide avec une faible consommation d'énergie a été obtenue avec ce type de dispositif (« Induction of coherent magnetization switching in a few atomic layers of FeCo using voltage pulse », Yoichi Shiota et al. Nature materials, 11, 39, 2012).

La possibilité de changer l'aimantation d'un film mince métallique magnétique avec un champ électrique est due à un changement dans l'anisotropie magnétique du film grâce au champ électrique appliqué. Etant donné que dans les métaux, le champ électrique est écranté sur une très courte distance, appelée « distance de Fermi » et qui est de 0,2 nm dans les métaux communément utilisés pour les électrodes des jonctions tunnel magnétiques, l'influence du champ électrique sur l'anisotropie est uniquement interfaciale. Dans le cas où le film mince ferromagnétique est en contact avec une couche isolante, un champ électrique peut être appliqué à travers la couche isolante et dans la couche métallique magnétique sur la distance d'écrantage de Fermi. Ce champ peut changer localement la densité d'état le long de l'interface entre la couche magnétique et la couche isolante, qui peut à son tour modifier l'anisotropie de surface qui existe à cette interface (« First-principles investigation of the very large perpendicular magnetic anisotropy at Fe/MgO and Co/MgO interfaces », Yang et al., Physical Review B 84, 054401, 2011). C'est le cas en particulier aux interfaces de type couche tampon/CoFeB/MgO ou couche tampon/FeCo/MgO, qui sont d'une très grande importance pratique dans les jonctions tunnel magnétiques. Cette modification entraîne un changement dans l'anisotropie effective $K_{eff}$, qui conduit à une anisotropie effective perpendiculaire au plan ou dans le plan, selon l'équation :

$$K_{eff} = -\frac{1}{2}\mu_0 M_s{}^2 + K_V + \frac{K_{s1}(V) + K_{s2}}{t_F}$$

Dans cette équation, $K_{s2}$ est l'anisotropie de surface à l'interface couche tampon/métal magnétique ; $K_{s1}$ est l'anisotropie de surface à l'interface métal magnétique/oxyde ; $-\frac{1}{2}\mu_0 M_s{}^2 + K_V$ est l'anisotropie de volume qui comprend dans son premier terme l'anisotropie de forme et dans son deuxième terme l'anisotropie magnétocristalline ; $t_F$ est l'épaisseur du film ferromagnétique.

L'anisotropie effective $K_{eff}$ est la somme des contributions des anisotropies de surface rapportées au volume en divisant par l'épaisseur du film ferromagnétique, et des anisotropies de volume.

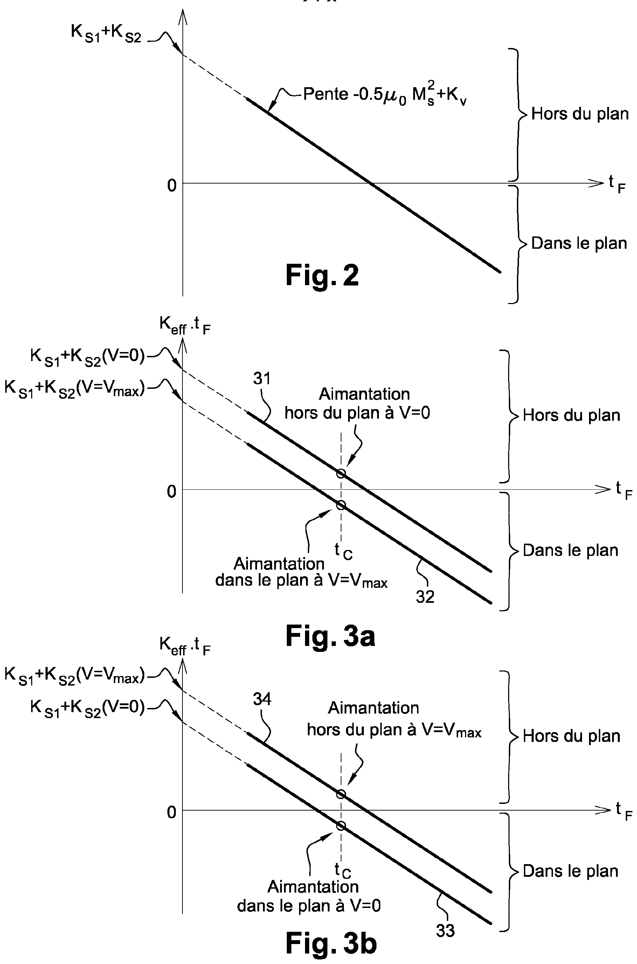

La figure 2 est une représentation graphique de l'évolution de l'anisotropie effective $K_{eff}$ multipliée par l'épaisseur $t_F$ du film ferromagnétique, en fonction de l'épaisseur $t_F$ du film ferromagnétique. Cette représentation graphique est une droite dont la pente est proportionnelle à la contribution de l'anisotropie de volume, c'est-à-dire à l'anisotropie de forme $-\frac{1}{2}\mu_0 M_s{}^2$, plus l'anisotropie magnétocristalline $K_V$, l'anisotropie magnétocristalline étant toutefois généralement négligeable dans les dispositifs mis en oeuvre.

Par convention, en magnétisme, lorsqu'une anisotropie effective est positive, l'aimantation est spontanément orientée hors du plan. Au contraire, lorsqu'une anisotropie est négative, l'aimantation est spontanément orientée dans le plan. Dès lors, dans toute la présente demande, un basculement d'anisotropie signifiera, par un abus de langage habituellement utilisé, un changement de signe de l'anisotropie qui conduit à un basculement spontané de l'orientation de l'aimantation de la couche considérée.

La contribution de l'anisotropie de forme est toujours une valeur négative car elle contribue systématiquement à une orientation de l'aimantation dans le plan.

L'intersection de la droite avec la droite d'équation $t_F = 0$ donne la contribution de l'anisotropie de surface $K_{s1} + K_{s2}$, qui est ici positive (voir figure 2) et contribue donc à une orientation de l'aimantation hors du plan.

Lorsqu'on applique un champ électrique, seule l'anisotropie de surface est susceptible d'être modifiée en raison de l'écrantage du champ dans l'électrode magnétique métallique, ce qui entraîne donc des changements dans les courbes. Ces changements sont expliqués en lien avec la figure 3a. La figure 3a montre :

- une première représentation graphique 31, lorsqu'aucune tension de polarisation n'est appliquée (V = 0), de l'anisotropie effective $K_{eff}$ multipliée par l'épaisseur $t_F$ du film ferromagnétique, en fonction de l'épaisseur $t_F$ du film ferromagnétique ;
- une deuxième représentation graphique 32, lorsqu'une tension de polarisation non nulle V = $V_{max}$ est appliquée aux bornes du dispositif, de l'anisotropie effective $K_{eff}$ multipliée par l'épaisseur $t_F$ du film ferromagnétique, en fonction de l'épaisseur $t_F$ du film ferromagnétique.

On observe une translation suivant l'axe des ordonnées de la deuxième représentation graphique 32 par rapport à la première représentation graphique 31.

Si l'épaisseur du film ferromagnétique est correctement choisie, comme illustré à la figure 3a pour une épaisseur $t_C$ du film ferromagnétique, la variation de l'anisotropie de surface peut entraîner un changement de signe de toute l'anisotropie effective. Dans le cas illustré à la figure 3a, on a ainsi une anisotropie perpendiculaire au plan lorsqu'aucune tension de polarisation n'est appliquée, et une anisotropie dans le plan lorsqu'un champ électrique est appliqué à travers l'interface métal magnétique/oxyde grâce à une tension de polarisation V = $V_{max}$ appliquée à travers la couche d'oxyde. Le cas contraire est également possible et est illustré à la figure 3b. La figure 3b montre :

- une troisième représentation graphique 33, lorsqu'aucune tension de polarisation n'est appliquée (V = 0), de l'anisotropie effective $K_{eff}$ multipliée par l'épaisseur $t_F$ du film ferromagnétique, en fonction de l'épaisseur $t_F$ du film ferromagnétique ;
- une quatrième représentation graphique 34, lorsqu'une tension de polarisation non nulle V = $V_{max}$ est appliquée, de l'anisotropie effective $K_{eff}$ multipliée par l'épaisseur $t_F$ du film ferromagnétique, en fonction de l'épaisseur $t_F$ du film ferromagnétique.

En partant d'une anisotropie dans le plan lorsqu'aucune tension de polarisation n'est appliquée (V = 0), on peut obtenir une anisotropie perpendiculaire au plan en appliquant une tension V = $V_{max}$. On obtient cette deuxième configuration en changeant l'anisotropie effective afin qu'elle soit négative lorsqu'aucune tension de polarisation n'est appliquée (V = 0) et en appliquant une tension de polarisation de signe inverse afin d'obtenir une anisotropie effective positive à V = V$_{max}$.

On peut donc contrôler le basculement de l'anisotropie effective, d'une direction perpendiculaire au plan à une direction dans le plan et vice versa, en fonction de l'application ou non d'une tension de polarisation. Prenons à titre d'exemple le cas d'une aimantation initiale selon une direction dans le plan, et d'une anisotropie effective :

- selon une direction dans le plan lorsqu'aucune tension de polarisation n'est appliquée,
- selon une direction perpendiculaire au plan lorsqu'une tension de polarisation est appliquée.

Durant l'application de la tension de polarisation, l'aimantation a un mouvement de précession autour de la direction, perpendiculaire au plan, de l'anisotropie effective. Cela conduit à une aimantation selon une direction hors du plan. Lorsqu'on cesse d'appliquer la tension de polarisation, l'anisotropie effective et l'aimantation retrouvent une direction dans le plan. Si l'on applique une tension de polarisation avec une durée correspondant exactement à une demi-période (modulo la période) de la précession de l'aimantation, alors l'aimantation effectue une rotation d'un angle $\pi$ rad par rapport à l'aimantation initiale. Ainsi l'aimantation finale est de sens contraire à l'aimantation initiale. Le contrôle du basculement de l'anisotropie effective permet donc un retournement précessionnel de l'aimantation.

Cependant, il est important de noter que le changement d'anisotropie de surface $\Delta K_{s1}(V) = K_{s1}(0) - K_{s1}(V)$ induit par le champ électrique est relativement faible. Avec un champ électrique accessible, c'est-à-dire inférieur au seuil de rupture diélectrique de la couche isolante qui est de l'ordre de 10$^9$ V/m, le changement d'anisotropie de surface $\Delta K_{s1}$ peut typiquement être aujourd'hui de l'ordre de 10% de la valeur de l'anisotropie de surface $K_{s1}(0)$ lorsqu'aucun champ électrique n'est appliqué. Pour que ce faible changement d'anisotropie provoque une importante variation d'aimantation, il faut, en jouant sur la composition des matériaux, les épaisseurs des différents matériaux ainsi que sur les différentes interfaces, ajuster l'anisotropie effective afin qu'elle se trouve proche d'une transition perpendiculaire au plan/dans le plan. A proximité de cette transition, une variation de l'anisotropie de surface de 10% peut en effet être suffisante pour que la direction d'aimantation subisse une rotation, d'une direction « hors du plan » vers une direction « dans le plan » et vice versa, grâce à l'application d'un champ électrique. Toutefois, si le système se trouve éloigné d'une telle transition perpendiculaire au plan/dans le plan pour l'anisotropie effective, la variation d'anisotropie de surface de 10% induite par la tension de polarisation ne permettra pas de changer l'orientation magnétique et donc ne permettra pas de commuter l'aimantation. Cela signifie qu'un tel phénomène d'anisotropie contrôlée en tension peut être utilisé en tant que nouveau moyen d'écriture basse-consommation dans un dispositif spintronique uniquement si l'on est capable de concevoir le dispositif spintronique considéré de façon qu'il se trouve proche d'une transition de réorientation d'anisotropie entre une direction « perpendiculaire au plan » et une direction « dans le plan », et ceci dans toute la gamme de température de fonctionnement souhaitée pour le dispositif.

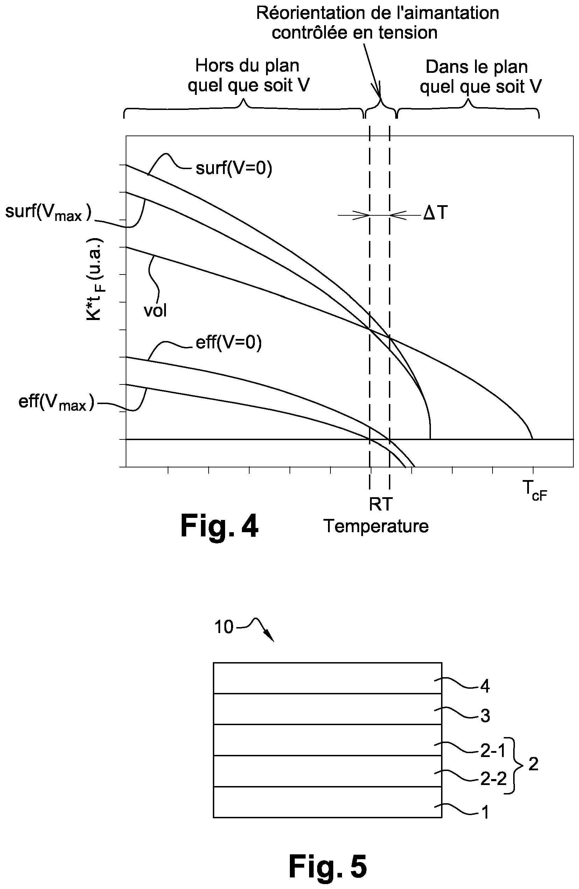

Comme expliqué précédemment, l'anisotropie effective est ajustée pour être proche d'une transition de réorientation d'anisotropie entre une direction « perpendiculaire au plan » et une direction « dans le plan » afin que le champ électrique soit capable de modifier suffisamment l'anisotropie de surface pour faire basculer la direction de l'anisotropie effective et ainsi pouvoir entraîner une réorientation de l'aimantation. Un problème important de l'art antérieur est que cette condition de proximité d'une transition de réorientation d'anisotropie n'est généralement satisfaite que sur une gamme de température très étroite, parce que les variations thermiques dans les films fins magnétiques de l'anisotropie de surface d'une part et de l'anisotropie volumique d'autre part sont généralement différentes. Ceci est illustré à la figure 4. La figure 4 montre :

- la courbe « surf(V=0) », lorsqu'aucune tension de polarisation n'est appliquée, de l'anisotropie de surface K$_S$ en fonction de la température ;
- la courbe « surf(V=V$_{max}$) », lorsqu'une tension de polarisation non nulle V=V$_{max}$ est appliquée, de l'anisotropie de surface K$_S$ en fonction de la température ;
- la courbe « vol » de la valeur absolue de l'anisotropie de volume multipliée par l'épaisseur du film $\left(\left(-\frac{1}{2}\mu_0 M_s{}^2 + K_V\right) * t_F\right)$ en fonction de la température ;
- la courbe « eff(V=0) », lorsqu'aucune tension de polarisation n'est appliquée, du produit de l'épaisseur du film et de l'anisotropie effective K$_{eff}$ en fonction de la température ;
- la courbe « eff(V=V$_{max}$) », lorsqu'une tension de polarisation non nulle V=V$_{max}$ est appliquée, du produit de l'épaisseur du film et de l'anisotropie effective K$_{eff}$ en fonction de la température.

L'anisotropie effective K$_{eff}$ lorsqu'aucune tension de polarisation n'est appliquée est la somme de l'anisotropie de surface $\frac{K_{S1}(V=0)+K_{S2}}{t_F}$ lorsqu'aucune tension de polarisation n'est appliquée et de l'anisotropie de volume. L'anisotropie effective $K_{eff}$ lorsqu'une tension de polarisation non nulle est appliquée est la somme de l'anisotropie de surface $\frac{K_{S1}(V) + K_{S2}}{t_F}$ lorsqu'une tension de polarisation non nulle est appliquée et de l'anisotropie de volume.

On s'attend généralement à ce que l'anisotropie de surface varie plus rapidement en température que l'anisotropie de volume, à cause du fait que les spins de surface ont une coordination inférieure aux spins de volume et sont donc plus sensibles aux fluctuations thermiques.

Une réorientation de l'aimantation avec un champ électrique est possible lorsque, pour une tension de polarisation nulle V=0, le signe de l'anisotropie effective $K_{eff}$ est positif (anisotropie perpendiculaire au plan) et lorsque, pour une tension de polarisation non nulle $V=V_{max}$, le signe de l'anisotropie effective $K_{eff}$ est négatif (anisotropie dans le plan). La figure 4 montre l'intervalle de température $\Delta T$ pour lequel la réorientation de l'aimantation avec un champ électrique est possible. Cet intervalle de température est très étroit.

Or la plupart des dispositifs électroniques doivent être capables de fonctionner dans une large gamme de température : entre 0°C et 70°C pour l'électronique grand public par exemple, ou entre -40°C et 85°C pour l'électronique industrielle. Sur de telles gammes de température, la condition de proximité d'une transition de réorientation d'anisotropie n'est pas respectée dans l'état de la technique. Ainsi, les dispositifs contrôlés en champ électrique proposés dans l'art antérieur ne peuvent fonctionner que dans une étroite gamme de température : ils pourront par exemple fonctionner correctement à 20°C, mais pas à 50°C.

## DESCRIPTION GENERALE DE L'INVENTION

L'invention offre une solution aux problèmes évoqués précédemment, en proposant un empilement multicouche dont l'anisotropie magnétique peut être contrôlée par un champ électrique et qui demeure proche d'une transition de réorientation entre une direction « perpendiculaire au plan » et une direction « dans le plan » sur une large gamme de température.

L'invention concerne donc essentiellement un dispositif magnétique contrôlé en tension comportant :

- une couche magnétique s'étendant suivant un plan de référence et présentant une aimantation à direction variable et une anisotropie effective $K_{eff}$ ;
- une couche isolante non magnétique s'étendant sur la couche magnétique ;
- une couche de contact s'étendant sur la couche isolante ;
- un moyen d'application d'une tension de polarisation entre la couche de contact et la couche magnétique, à travers la couche isolante non magnétique ;

ladite couche magnétique présentant un seuil de basculement d'anisotropie tel que l'application d'une tension de polarisation $V_{max}$ à travers la couche isolante permet le basculement de l'anisotropie effective $K_{eff}$ d'une direction perpendiculaire au plan de référence à une direction dans le plan de référence ou inversement, la couche magnétique dudit dispositif magnétique comportant :

- une première couche, dite « couche de volume », d'épaisseur $t_B$, présentant une première anisotropie de volume $K_{VB}$ ;
- une deuxième couche, dite « couche de surface », d'épaisseur $t_A$, présentant une anisotropie de surface $K_{SA}$ et une deuxième anisotropie de volume $K_{VA}$, la couche de surface se trouvant entre la couche de volume et la couche isolante non magnétique ;

la composition et l'épaisseur des couches de surface et de volume étant choisies afin que l'anisotropie de surface $K_{SA}$ et les première et deuxième anisotropies de volume $K_{VB}$ et $K_{VA}$ respectent, sur une gamme de fonctionnement en température donnée, l'inéquation suivante :

$$Min\big(K_{SA}(V=0), K_{SA}(V=V_{max})\big) < -(K_{VB}t_B + K_{VA}t_A)$$
$$< Max\big(K_{SA}(V=0), K_{SA}(V=V_{max})\big)$$

où $K_{SA}(V=0)$ est l'anisotropie de surface lorsqu'aucune tension de polarisation n'est appliquée et $K_{SA}(V=V_{max})$ est l'anisotropie de surface lorsque la tension de polarisation $V_{max}$ est appliquée.

On entend par « une première anisotropie de volume $K_{VB}$ » l'anisotropie effective de ladite première couche, qui comprend l'anisotropie volumique propre et les anisotropies de surface des deux interfaces de cette première couche avec les couches adjacentes. Les anisotropies de surface aux interfaces n'apparaissent pas explicitement car elles ne sont pas modifiées lors de l'application d'une tension, le champ électrique étant rapidement écranté.

Grâce à l'invention, on utilise avantageusement une couche magnétique comportant une couche de volume et une couche de surface. La couche de volume présente une première anisotropie de volume $K_{VB}$ et la couche de surface présente une anisotropie de surface $K_{SA}$ et une deuxième anisotropie de volume $K_{VA}$. La couche magnétique présente une anisotropie effective $K_{eff}$ qui est la somme, rapportée au volume, des première et deuxième anisotropies de volume $K_{VB}$ et $K_{VA}$, respectivement pondérées par l'épaisseur $t_B$ de la première couche et par l'épaisseur $t_A$ de la deuxième couche, et de l'anisotropie de surface $K_{SA}$ :

$$K_{eff} = \frac{K_{VA}t_A + K_{VB}t_B + K_{SA}}{t_A + t_B}.$$

Si les première et deuxième anisotropies de volume $K_{VB}$ et $K_{VA}$ sont dans une direction dans le plan de référence, alors l'anisotropie de surface $K_{SA}$ est dans une direction hors du plan de référence. Si les première et deuxième anisotropies de volume $K_{VB}$ et $K_{VA}$ sont dans une direction hors du plan de référence, alors l'anisotropie de surface $K_{SA}$ est dans une direction dans le plan de référence. L'invention permet donc, en dissociant la couche magnétique en une couche de volume et une couche de surface, de contrôler indépendamment l'évolution en température de l'anisotropie de surface $K_{SA}$ et l'évolution en température de la première anisotropie de volume $K_{VB}$.

On parvient ainsi, en optimisant la composition et l'épaisseur des couches de surface et de volume, à ajuster les courbes thermiques de l'anisotropie de surface $K_{SA}$ et de la première anisotropie de volume $K_{VB}$, et donc à contrôler l'anisotropie effective $K_{eff}$ pour qu'elle demeure, sur une large gamme de température, proche d'une transition de réorientation entre une direction perpendiculaire au plan de référence et une direction dans le plan de référence.

Outre les caractéristiques qui viennent d'être évoquées dans le paragraphe précédent, le dispositif magnétique selon l'invention peut présenter une ou plusieurs caractéristiques complémentaires parmi les suivantes, considérées individuellement ou selon toutes les combinaisons techniquement possibles.

La couche isolante est avantageusement réalisée en MgO, AlOx, AlN, $SrTiO_3$, HfOx ou tout autre oxyde ou nitride isolant présentant une polarisabilité diélectrique supérieure ou égale à 6.

Avantageusement, selon des premier et troisième modes de réalisation :

- l'anisotropie effective $K_{eff}$ est dans une direction perpendiculaire au plan de référence lorsqu'aucune tension de polarisation n'est appliquée ;
- l'anisotropie effective $K_{eff}$ est dans une direction dans le plan de référence lorsque la tension de polarisation $V_{max}$ est appliquée.

Selon le premier mode de réalisation :

- l'anisotropie de surface $K_{SA}$ de la couche de surface est dans une direction perpendiculaire au plan de référence et l'anisotropie de surface $K_{SA}$ décroît lorsqu'on applique la tension de polarisation $V_{max}$ ;
- l'anisotropie de volume totale $K_{VB}t_B + K_{VA}t_A$ est dans une direction dans le plan de référence.

Un dispositif magnétique selon l'invention nécessite en effet que l'anisotropie de surface $K_{SA}$ de la couche de surface puisse compenser la première anisotropie de volume $K_{VB}$ de la couche de volume. Or il est plus simple, en pratique, d'obtenir une anisotropie de surface forte dans une direction perpendiculaire au plan de référence, que d'obtenir une anisotropie de surface forte dans une direction dans le plan de référence.

Selon le troisième mode de réalisation :

- l'anisotropie de surface $K_{SA}$ de la couche de surface est dans une direction dans le plan de référence et l'anisotropie de surface $K_{SA}$ croît lorsqu'on applique la tension de polarisation $V_{max}$ ;
- l'anisotropie de volume totale $K_{VB}t_B + K_{VA}t_A$ est dans une direction perpendiculaire au plan de référence.

Avantageusement, selon des deuxième et quatrième modes de réalisation :

- l'anisotropie effective $K_{eff}$ est dans une direction dans le plan de référence lorsqu'aucune tension de polarisation n'est appliquée ;
- l'anisotropie effective $K_{eff}$ est dans une direction perpendiculaire au plan de référence lorsque la tension de polarisation $V_{max}$ est appliquée.

Selon le deuxième mode de réalisation :

- l'anisotropie de surface $K_{SA}$ de la couche de surface est dans une direction perpendiculaire au plan de référence et l'anisotropie de surface $K_{SA}$ croît lorsqu'on applique la tension de polarisation $V_{max}$ ;
- l'anisotropie de volume totale $K_{VB}t_B + K_{VA}t_A$ est dans une direction dans le plan de référence.

Un dispositif magnétique selon l'invention nécessite en effet que l'anisotropie de surface $K_{SA}$ de la couche de surface puisse compenser la première anisotropie de volume $K_{VB}$ de la couche de volume. Or il est plus simple, en pratique, d'obtenir une anisotropie de surface forte dans une direction perpendiculaire au plan de référence, que d'obtenir une anisotropie de surface forte dans une direction dans le plan de référence.

Selon le quatrième mode de réalisation :

- l'anisotropie de surface $K_{SA}$ de la couche de surface est dans une direction dans le plan de référence et l'anisotropie de surface $K_{SA}$ décroît lorsqu'on applique la tension de polarisation $V_{max}$ ;
- l'anisotropie de volume totale $K_{VB}t_B + K_{VA}t_A$ est dans une direction perpendiculaire au plan de référence.

Avantageusement, selon les premier et deuxième modes de réalisation, la couche de surface est réalisée avec un alliage à base de Co, Fe, Ni ou tout autre matériau conduisant, en combinaison avec la couche isolante, à une anisotropie de surface $K_{SA}$ perpendiculaire au plan de référence et présentant une variation supérieure à 5 % en fonction de l'application ou non de la tension de polarisation $V_{max}$.

Selon l'un quelconque des modes de réalisation, la couche de volume présentant la première anisotropie de volume $K_{VB}$ est avantageusement un empilement multicouche de n motifs élémentaires de type F1/N1 ou F1/N1/F2/N2 ou F1/F2, avec F1 et F2 deux matériaux ferromagnétiques différents et N1 et N2 deux matériaux non magnétiques différents.

Selon l'un quelconque des modes de réalisation, la couche de volume présentant la première anisotropie de volume $K_{VB}$ est avantageusement un alliage présentant une structure tétragonale $L1_0$.

Selon l'un quelconque des modes de réalisation, la couche de volume présentant la première anisotropie de volume $K_{VB}$ est avantageusement une monocouche d'un alliage de type F1F2F3N1N2, avec F1, F2 et F3 trois matériaux ferromagnétiques différents et N1 et N2 deux matériaux non magnétiques différents.

Alternativement et selon l'un quelconque des modes de réalisation :

- la couche de contact comporte, au contact de la couche isolante non magnétique, une couche magnétique présentant une direction d'aimantation fixe servant de direction de référence pour l'aimantation ;
- la couche isolante non magnétique est une barrière tunnel permettant à un courant de circuler par effet tunnel entre la couche de contact et la couche magnétique ;

le dispositif se comportant alors comme une jonction tunnel magnétique.

Selon cette alternative de l'un quelconque des modes de réalisation, le dispositif présente avantageusement les caractéristiques suivantes :

- la couche magnétique de la couche de contact est un alliage de CoFeB ;
- la couche isolante non magnétique est réalisée en MgO ;
- la couche de surface de la couche magnétique est un alliage de CoFeB.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention. Les figures montrent :

- A la figure 1a, une représentation schématique d'une cellule mémoire à écriture par champ magnétique selon l'état de l'art ;
- A la figure 1b, une représentation schématique d'une cellule mémoire magnétique à écriture par transfert de spin avec une aimantation « dans le plan » selon l'état de l'art ;
- A la figure 1c, une représentation schématique d'une cellule mémoire magnétique à écriture par transfert de spin avec une aimantation « perpendiculaire au plan » selon l'état de l'art ;
- A la figure 1d, une représentation schématique d'une cellule mémoire à écriture par champ magnétique thermiquement assistée selon l'état de l'art ;

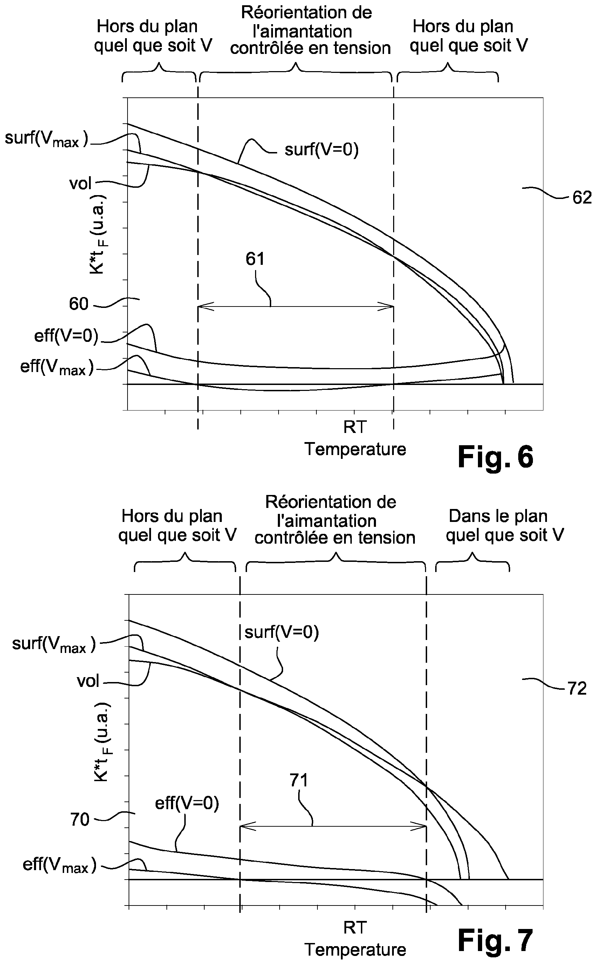

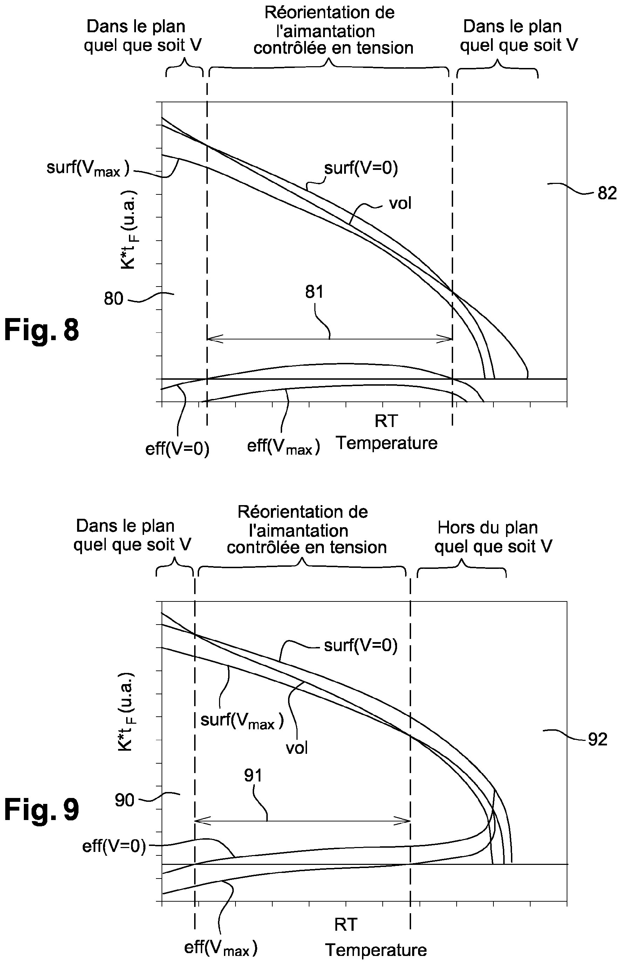

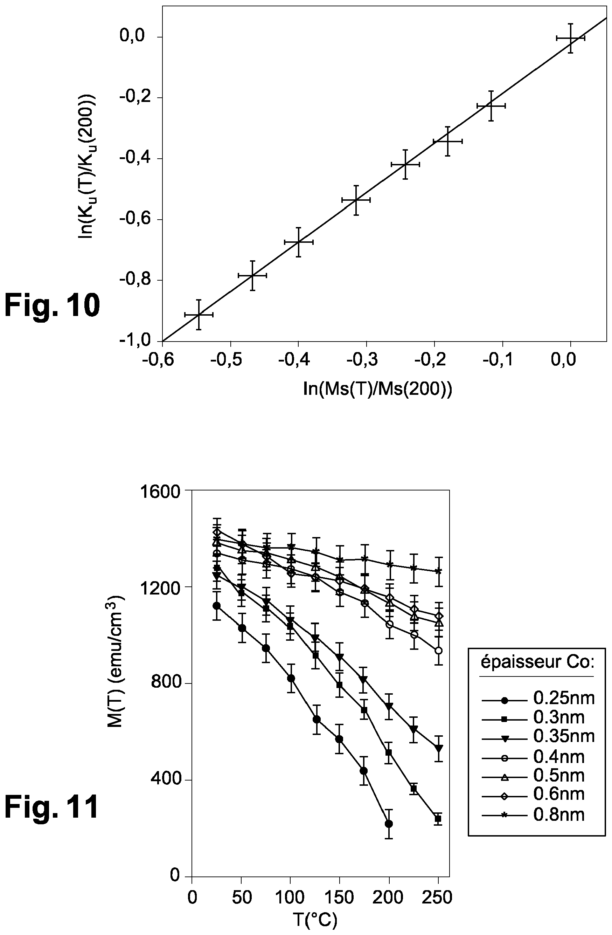

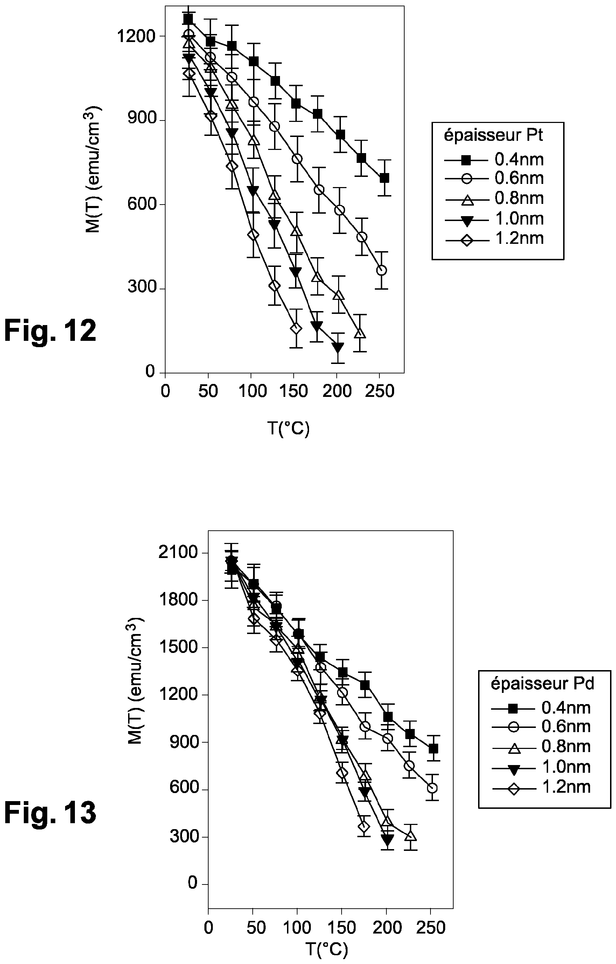

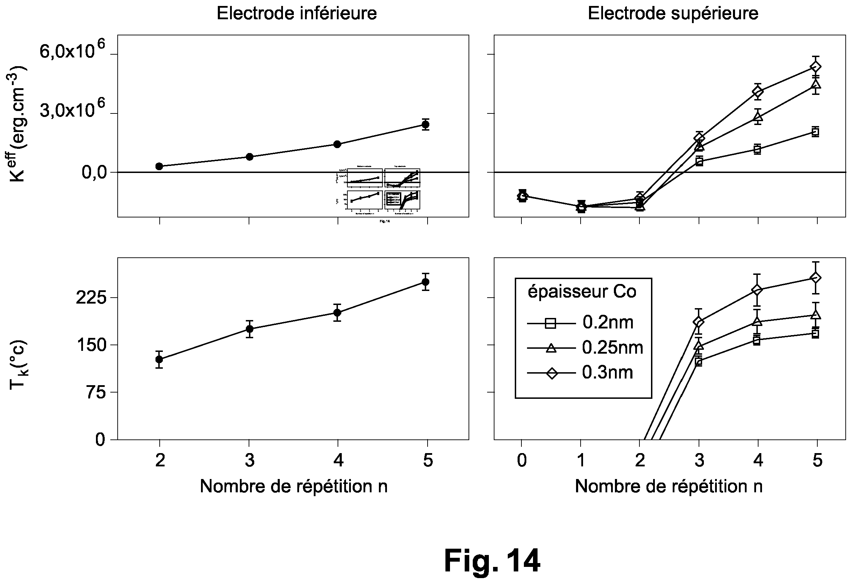

- A la figure 1e, une représentation schématique d'une cellule mémoire magnétique à écriture par transfert de spin thermiquement assistée avec une aimantation « dans le plan » selon l'état de l'art ;
- A la figure 1f, une représentation schématique d'une cellule mémoire magnétique à écriture par transfert de spin thermiquement assistée avec une aimantation « perpendiculaire au plan » selon l'état de l'art ;
- A la figure 2, une représentation graphique de l'évolution de l'anisotropie effective multipliée par l'épaisseur du film ferromagnétique en fonction de l'épaisseur du film ferromagnétique dans une cellule mémoire magnétique selon l'état de l'art ;
- A la figure 3a, une représentation graphique de l'évolution de l'anisotropie effective multipliée par l'épaisseur du film ferromagnétique en fonction de l'épaisseur du film ferromagnétique dans une cellule mémoire magnétique et en fonction de l'application ou non d'un champ électrique, selon une première configuration selon l'état de l'art ;
- A la figure 3b, une représentation graphique de l'évolution de l'anisotropie effective multipliée par l'épaisseur du film ferromagnétique en fonction de l'épaisseur du film ferromagnétique dans une cellule mémoire magnétique et en fonction de l'application ou non d'un champ électrique, selon une deuxième configuration selon l'état de l'art ;
- A la figure 4, une représentation graphique de l'évolution de l'anisotropie de surface, de la valeur absolue de l'anisotropie de volume multipliée par l'épaisseur du film ferromagnétique et de l'anisotropie effective multipliée par l'épaisseur du film ferromagnétique en fonction de la température et en fonction de l'application ou non d'une tension de polarisation produisant un champ électrique dans une cellule mémoire magnétique selon l'état de l'art ;
- A la figure 5, une représentation schématique d'un dispositif selon l'invention ;
- A la figure 6, une représentation graphique de l'évolution de l'anisotropie de surface, de la valeur absolue de l'anisotropie de volume multipliée par l'épaisseur du film ferromagnétique et de l'anisotropie effective multipliée par l'épaisseur du film ferromagnétique en fonction de la température et en fonction de l'application ou non d'un champ électrique dans une cellule mémoire magnétique selon une première variante d'un premier mode de réalisation ;
- A la figure 7, une représentation graphique de l'évolution de l'anisotropie de surface, de la valeur absolue de l'anisotropie de volume multipliée par l'épaisseur du film ferromagnétique et de l'anisotropie effective multipliée par l'épaisseur du film ferromagnétique en fonction de la température et en fonction de l'application ou non d'un champ électrique dans une cellule mémoire magnétique selon une deuxième variante du premier mode de réalisation ;
- A la figure 8, une représentation graphique de l'évolution de l'anisotropie de surface, de la valeur absolue de l'anisotropie de volume multipliée par l'épaisseur du film ferromagnétique et de l'anisotropie effective multipliée par l'épaisseur du film ferromagnétique en fonction de la température et en fonction de l'application ou non d'un champ électrique dans une cellule mémoire magnétique selon une troisième variante du premier mode de réalisation ;
- A la figure 9, une représentation graphique de l'évolution de l'anisotropie de surface, de la valeur absolue de l'anisotropie de volume multipliée par l'épaisseur du film ferromagnétique et de l'anisotropie effective multipliée par l'épaisseur du film ferromagnétique en fonction de la température et en fonction de l'application ou non d'un champ électrique dans une cellule mémoire magnétique selon une quatrième variante du premier mode de réalisation ;
- A la figure 10, une représentation graphique en échelle logarithmique de l'évolution de l'anisotropie de surface en fonction de la température, pour une interface de type Co/AlOx avec une épaisseur de Co de 2 nm ;
- A la figure 11, une représentation graphique de l'évolution de l'aimantation en fonction de la température pour une multicouche de type $Ta_3/Pt_5/(CO_{tCo}/CU_{0,4}/Pt_{0,4})_5)/CU_2/Pt_2$ et pour différentes épaisseurs de Co ;
- A la figure 12, une représentation graphique de l'évolution de l'aimantation en fonction de la température pour des multicouches de $Ta_3/Pt_5/(Co_{0,3}/Pt_{tPt})_5/Cu_2/Pt_2$ et pour différentes épaisseurs de Pt ;
- A la figure 13, une représentation graphique de l'évolution de l'aimantation en fonction de la température pour des multicouches de $Ta_3/Pd_5/(CO_{0,3}/Pd_{tPd})_5/Cu_2/Pd_2$ et pour différentes épaisseurs de Pd ;
- A la figure 14a, une représentation graphique de l'évolution de l'anisotropie effective dans une multicouche de type (Co/Pt)n utilisée comme électrode inférieure, en fonction du nombre n de répétition de la multicouche ;
- A la figure 14b, une représentation graphique de l'évolution de la température de transition dans une multicouche de type (Co/Pt)n utilisée comme électrode inférieure, en fonction du nombre n de répétition de la multicouche ;
- A la figure 14c, une représentation graphique de l'évolution de l'anisotropie effective dans une multicouche de type (Co/Pd)n utilisée comme électrode supérieure, en fonction de nombre n de répétition de la multicouche et pour différentes épaisseurs de Co ;
- A la figure 14d, une représentation graphique de l'évolution de la température de transition dans une multicouche de type (Co/Pd)n utilisée comme électrode supérieure, en fonction de nombre n de répétition de la multicouche et pour différentes épaisseurs de Co.

**DESCRIPTION DETAILLEE D'AU MOINS UN MODE DE REALISATION DE**

**L'INVENTION**

Sauf précision contraire, un même élément apparaissant sur des figures différentes présente une référence unique.

Un dispositif 10 selon l'invention est représenté schématiquement à la figure 5. Ce dispositif 10 comprend :

- une couche tampon 1 s'étendant suivant un plan de référence ;
- une couche magnétique 2 présentant une anisotropie effective $K_{eff}$ et s'étendant sur la couche tampon 1 ;
- une couche isolante non magnétique 3 s'étendant sur la couche magnétique 2 ;
- une couche de contact 4 s'étendant sur la couche isolante non magnétique 3 et permettant d'appliquer une tension de polarisation à travers la couche isolante non magnétique 3.

Le dispositif peut bien entendu être inversé de sorte que la couche de contact se retrouve dans le plan de référence avec une couche isolante non magnétique s'étendant sur la couche de contact et une couche magnétique présentant une anisotropie effective $K_{eff}$ et s'étendant sur la couche tampon.

Dans ce document, sauf mention contraire, les expressions « hors du plan », « perpendiculaire au plan » et « dans le plan » s'entendent par rapport au plan de référence.

La couche magnétique 2 comprend elle-même deux couches magnétiquement couplées :

- une couche de surface 2-1 présentant une anisotropie de surface $K_{SA}$ et une deuxième anisotropie de volume $K_{VA}$,
- une couche de volume 2-2 présentant une première anisotropie de volume $K_{VB}$.

L'anisotropie de surface de la couche de surface 2-1 et l'anisotropie de volume de la couche de volume 2-2 contribuent à l'anisotropie effective $K_{eff}$ de la couche magnétique 2.

La couche de surface 2-1 et la couche de surface 2-2 peuvent être séparées par une fine couche en matériau non magnétique (non représentée) permettant d'assurer une transition structurale entre la structure du matériau de la couche de surface 2-1 et la structure du matériau de la couche de volume 2-2 tout en maintenant un fort couplage magnétique entre l'aimantation de la couche de surface 2-1 et celle de la couche de volume 2-2. Cette fine couche non magnétique peut par exemple être en Tantale, en Titane ou en Ruthénium avec une épaisseur comprise entre 0,2 et 1 nm.

La couche tampon 1 peut avoir une ou plusieurs fonctions parmi les suivantes :

- servir d'électrode arrière afin de permettre un contact électrique avec le dispositif 10 ;
- contribuer à la croissance du dispositif 10 ;
- contribuer à créer une anisotropie qui sera incluse dans l'anisotropie $K_{VB}$.

La couche tampon 1 peut par exemple être réalisée en Ta, NiFeCr, Ru, Ta/Ru. L'épaisseur de cette couche tampon 1 est typiquement comprise entre 0,2 et 100 nm.

L'intérêt de la couche isolante non magnétique 3 est de permettre l'application d'un champ électrique à l'interface entre la couche isolante non magnétique 3 et la couche magnétique 2. Dans le cas où le dispositif 10 est une jonction tunnel magnétique, la couche isolante non magnétique 3 est une barrière tunnel, typiquement en MgO, et permet au courant de circuler par effet tunnel entre la couche de contact 4 et la couche magnétique 2. La couche de contact 4 est alors réalisée dans un matériau magnétique. Un phénomène de magnétorésistance tunnel est alors mis en jeu, contrôlé par l'orientation relative de l'aimantation, respectivement dans la couche de contact 4 et dans la couche magnétique 2.

La couche de contact 4 peut être constituée de plusieurs couches et réaliser les fonctions suivantes :

- établir un contact électrique à l'avant du dispositif 10 afin de pouvoir générer un champ électrique à l'interface entre la couche isolante non magnétique 3 et la couche magnétique 2 ;
- dans le cas où le dispositif 10 est une jonction tunnel magnétique, agir comme une couche magnétique de référence afin que la jonction tunnel magnétique présente un effet de magnétorésistance tunnel contrôlé par l'orientation relative de l'aimantation, respectivement dans la couche de contact 4 et dans la couche magnétique 2.

Cette structure peut être inversée, c'est-à-dire que la couche magnétique 2 peut être au-dessus de la couche de contact 4. Dans le cas où le dispositif 10 est une jonction tunnel magnétique, la couche de contact 4 peut être une couche ferromagnétique avec une direction d'aimantation fixe, par exemple une direction d'aimantation piégée, servant de direction de référence pour l'aimantation.

La couche de contact 4 peut typiquement être réalisée en CuN, ou avec une multicouche de Ta, Au, Cr, Ru, Cu ou (Cu/Ta). Dans le cas où le dispositif 10 est une jonction tunnel magnétique, alors la couche de contact 4 doit contenir une couche magnétique au contact de la couche isolante non magnétique 3 afin de générer une magnétorésistance tunnel. Cette couche magnétique peut par exemple être un alliage de CoFeB, au contact d'une couche isolante en MgO.

La composition de la couche de surface 2-1 et la nature de la couche isolante non magnétique 3 sont choisies afin d'avoir une importante anisotropie, dans une direction perpendiculaire au plan ou dans une direction dans le plan, et afin que cette anisotropie présente une variation prononcée en fonction d'un champ électrique.

La couche de volume 2-2 est composée par un matériau ferromagnétique différent de celui de la couche de surface 2-1, ou par le même matériau ferromagnétique que celui de la couche de surface 2-1 mais avec une composition différente. La composition de la couche de volume 2-2 est choisie de telle sorte que l'anisotropie de volume de la couche de volume 2-2 est ajustée afin d'avoir une anisotropie effective de la couche magnétique 2 proche d'une transition entre une direction perpendiculaire au plan et une direction dans le plan.

De plus, la composition du matériau ferromagnétique de la couche de volume 2-2 est choisie par rapport au matériau ferromagnétique de la couche de surface 2-1 de manière que la variation thermique de l'anisotropie de volume totale $K_{VB}t_B + K_{VA}t_A$ corresponde quasiment, typiquement à 10% près en valeur relative, à la variation thermique de l'anisotropie de surface sur la gamme de température de fonctionnement du dispositif 10.

En conséquence, l'anisotropie totale de la couche magnétique 2 est optimisée sur une large gamme de température afin de satisfaire les spécifications requises par l'application souhaitée. Dans un tel dispositif 10, l'effet du champ électrique est en effet suffisant pour changer le signe de l'anisotropie magnétique de la couche magnétique 2, permettant ainsi une réorientation de l'aimantation contrôlée en tension, dans toute la gamme de température de fonctionnement du dispositif 10.

L'ajustement des anisotropies de surface et de volume est effectué afin d'obtenir une large gamme de température de fonctionnement pour le dispositif 10. Dans ce but, dans la gamme de température souhaitée, on optimise l'anisotropie de sorte que :

- l'anisotropie effective en l'absence de champ électrique $K_{eff}$ (V=0) soit positive,
- et, dans le même temps, l'anisotropie effective en présence d'un champ électrique $K_{eff}$ (V=$V_{max}$) soit négative.

De même pour un autre mode de réalisation, dans la gamme de température souhaitée, on optimise l'anisotropie de sorte que :

- l'anisotropie effective en l'absence de champ électrique $K_{eff}$ (V=0) soit négative,
- et, dans le même temps, l'anisotropie effective en présence d'un champ électrique $K_{eff}$ (V=$V_{max}$) soit positive.

En choisissant les matériaux (nature et épaisseur), on ajuste les variations thermiques relatives de l'anisotropie de surface et de l'anisotropie de volume, afin que, pour une gamme de température couvrant au moins la gamme de température de fonctionnement souhaitée pour le dispositif 10 final, la courbe de variation thermique de l'anisotropie de volume totale se trouve entre la courbe de variation thermique de l'anisotropie de surface lorsqu'aucune tension n'est appliquée et la courbe de variation thermique de l'anisotropie de surface lorsqu'une tension $V_{max}$ est appliquée.

Les caractéristiques de différentes couches et des différentes solutions pour obtenir une transition de réorientation d'anisotropie sur une large gamme de température de fonctionnement sont détaillées dans la suite de ce document.

L'anisotropie de surface de la couche de surface 2-1 peut être dans une direction perpendiculaire au plan ou dans une direction dans le plan.

- Lorsque l'anisotropie de surface de la couche de surface 2-1 est dans une direction perpendiculaire au plan, l'anisotropie de volume de la couche de volume 2-2 est dans une direction dans le plan.
- Au contraire, lorsque l'anisotropie de surface de la couche de surface 2-1 est dans une direction dans le plan, l'anisotropie de volume de la couche de volume 2-2 est dans une direction perpendiculaire au plan.

L'anisotropie effective de la couche magnétique 2 peut se trouver :

- dans une direction perpendiculaire au plan lorsqu'aucune tension de polarisation n'est appliquée et dans une direction dans le plan lorsqu'une tension de polarisation est appliquée,
- ou bien dans une direction dans le plan lorsqu'aucune tension de polarisation n'est appliquée et dans une direction perpendiculaire au plan lorsqu'une tension de polarisation est appliquée.

Ainsi, selon un premier mode de réalisation :

- l'anisotropie de surface $K_{SA}$ est dans une direction perpendiculaire au plan et les première et deuxième anisotropies de volume $K_{VB}$ et $K_{VA}$ sont dans une direction dans le plan ;

- l'anisotropie effective $K_{eff}$ est dans une direction perpendiculaire au plan lorsqu'aucune tension de polarisation n'est appliquée et dans une direction dans le plan lorsqu'une tension de polarisation $V_{max}$ est appliquée.

Des première, deuxième, troisième et quatrième variantes de ce premier mode de réalisation de l'invention sont respectivement illustrées aux figures 6, 7, 8 et 9.

Selon la première variante du premier mode de réalisation de l'invention, illustrée à la figure 6 :

- pour un domaine 60 de basses températures et pour un domaine 62 de hautes températures, le dispositif 10 présente une anisotropie perpendiculaire au plan, c'est-à-dire une anisotropie effective $K_{eff} > 0$, quelle que soit la tension appliquée ;
- pour un large domaine 61 de températures intermédiaires, le dispositif présente une anisotropie dans le plan, c'est-à-dire une anisotropie effective $K_{eff} < 0$, lorsqu'une tension de polarisation non nulle $V=V_{max}$ est appliquée, et conserve une anisotropie perpendiculaire au plan ($K_{eff} > 0$) lorsqu'aucune tension de polarisation n'est appliquée.

Selon la deuxième variante du premier mode de réalisation de l'invention, illustré à la figure 7 :

- pour un domaine 70 de basses températures, le dispositif 10 présente une anisotropie perpendiculaire au plan ($K_{eff} > 0$) quelle que soit la tension de polarisation appliquée ;
- pour un domaine 72 de hautes températures, le dispositif 10 présente une anisotropie dans le plan ($K_{eff} < 0$) quelle que soit la tension de polarisation appliquée ;
- pour un large domaine 71 de températures intermédiaires, le dispositif 10 présente une anisotropie perpendiculaire au plan ($K_{eff} > 0$) lorsqu'aucune tension de polarisation n'est appliquée et une anisotropie dans le plan ($K_{eff} < 0$) lorsqu'une tension de polarisation non nulle $V=V_{max}$ est appliquée.

Selon la troisième variante du premier mode de réalisation de l'invention, illustrée à la figure 8 :

- pour un domaine 80 de basses températures et pour un domaine 82 de hautes températures, le dispositif 10 présente une anisotropie dans le plan ($K_{eff} < 0$) quelle que soit la tension de polarisation appliquée ;
- pour un large domaine 81 de températures intermédiaires, le dispositif 10 présente une anisotropie perpendiculaire au plan ($K_{eff} > 0$) lorsqu'aucune tension de polarisation n'est appliquée et une anisotropie dans le plan ($K_{eff} < 0$) lorsqu'une tension de polarisation non nulle $V=V_{max}$ est appliquée.

Selon la quatrième variante du premier mode de réalisation de l'invention, illustrée à la figure 9 :

- pour un domaine 90 de basses températures, le dispositif 10 présente une anisotropie dans le plan ($K_{eff} < 0$) quelle que soit la tension de polarisation appliquée ;
- pour un domaine 92 de hautes températures, le dispositif 10 présente une anisotropie perpendiculaire au plan ($K_{eff} > 0$) quelle que soit la tension de polarisation appliquée ;
- pour un large domaine 91 de températures intermédiaires, le dispositif 10 présente une anisotropie perpendiculaire au plan ($K_{eff} > 0$) lorsqu'aucune tension de polarisation n'est appliquée et une anisotropie dans le plan ($K_{eff} < 0$) lorsqu'une tension de polarisation non nulle $V=V_{max}$ est appliquée.

Le dispositif 10 peut être élaboré grâce à des techniques de dépôt physique en phase vapeur (« physical vapor deposition » en langue anglaise), et en particulier grâce à une pulvérisation cathodique (« direct current sputtering » en langue anglaise) ou grâce à une pulvérisation cathodique radiofréquence (« radio frequency sputtering » en langue anglaise).

La couche isolante non magnétique 3 est typiquement réalisée en MgO, AlOx, AlN, $SrTiO_3$, HfOx, TaOx ou toute autre couche isolante d'oxyde ou de nitride. Tout matériau présentant une grande polarisabilité diélectrique, par exemple supérieure ou égale à 6, comme $HfO_2$ ou $SrTiO_3$, est avantageux en ce qu'il contribue à accroître l'amplitude du champ électrique créé à l'interface entre la couche isolante non magnétique 3 et la couche magnétique 2. L'épaisseur de la couche isolante non magnétique 3 est typiquement comprise entre 0,5 et 2,5 nm.

Si le dispositif 10 est une jonction tunnel magnétique, alors la couche isolante non magnétique 3 doit être une barrière tunnel présentant un ratio important de magnétorésistance tunnel, typiquement au-dessus de 20% à température ambiante.

Il a été montré que le phénomène d'anisotropie perpendiculaire à une interface métal magnétique/oxyde est plutôt généralisé (voir en particulier « Crossover from in-plane to perpendicular anisotropy in Pt/CoFe/AlOx as a function of the Al degree of oxidation : a very accurate control of the oxydation of tunnel barrier », S. Monso et al., Appl. Phys.

Lett. 80, 4157 (2002) ou « Analysis of oxygen induced anisotropy crossover in Pt/Co/MOx trilayers », A. Manchon et al., J. Appl. Phys. 104, 043914 (2008)). En conséquence, pour former la couche de surface 2-1 de la couche magnétique 2, les alliages à base de Co, de Fe ou de Ni, ou les autres matériaux conduisant à une anisotropie de surface perpendiculaire avec la couche isolante non magnétique 3 et à une influence importante du champ électrique sur l'anisotropie de surface, sont adaptés. Dans le cas où le dispositif 10 est une jonction tunnel magnétique, alors cette couche de surface 2-1 de la couche magnétique 2 doit également présenter une importante magnétorésistance tunnel, typiquement supérieure à 20%. A cette fin, les alliages de $(Co_{1-x}Fe_x)_{1-y}B_y$ sont particulièrement adaptés, avec la teneur (y) en B comprise entre 10% et 25% et la teneur (x) en Fe comprise entre 20% et 80%. L'épaisseur de cette couche de surface 2-1 est typiquement comprise entre 0,2 et 1,5 nm.

Dans ce premier mode de réalisation, la couche de volume 2-2 de la couche magnétique 2 peut être :

- une multicouche avec une anisotropie de volume dans le plan, composée de n répétitions d'une bicouche de type F1/N1, d'une bicouche de type F1/F2 ou d'une quadricouche de type F1/N1/F2/N2, où F1 et F2 sont deux matériaux ferromagnétiques, comme par exemple Fe, Co, Ni, Gd et leurs alliages, et N1 et N2 sont deux matériaux non magnétiques, comme par exemple Cu, Cr, Ta, Ti, Hf, Mo, Ag, Au, Pd, Pt ;
- une couche simple avec une anisotropie de volume dans le plan, réalisée dans un alliage tel que du FePt, FePd, FeNiPt, FeNiPd, FeCuPt ou FeCuPd, présentant une structure tétragonale $L1_0$ avec la distorsion tétragonale orientée dans le plan;
- une couche simple avec une anisotropie de volume dans le plan, réalisée dans un alliage de type F1 F2F3N1 N2, où F1, F2 et F3 sont trois matériaux ferromagnétiques, par exemple du Fe, Co, Ni, Gd et leurs alliages, et N1 et N2 sont deux matériaux non magnétiques, par exemple du Cr, Ta, Cu, Hf, Ti, Nb, Zr, Mo, Ag, Au, Pd, Pt. Des exemples d'alliages possibles sont ainsi : CoCr, CoCrPt, CoCrTa, FeNiTa, CoFeCrPt. L'intérêt du dopage non magnétique est de réduire l'anisotropie de volume dans le plan afin d'avoir une anisotropie effective $K_{eff}$ suffisamment proche de zéro et pouvoir changer son signe grâce à l'application d'un champ électrique ;

La couche de volume 2-2 présente une épaisseur $t_B$, typiquement comprise entre 0,2 et 10 nm, qui est choisie suffisamment faible pour que, lorsqu'aucune tension de polarisation n'est appliquée, l'anisotropie de surface perpendiculaire au plan l'emporte sur l'anisotropie de volume dans le plan, conduisant à une anisotropie effective $K_{eff}$ perpendiculaire au plan lorsqu'aucune tension de polarisation n'est appliquée.

L'ajustement des anisotropies de surface et de volume, afin d'obtenir notamment les conditions des premier, deuxième, troisième et quatrième modes de réalisation de l'invention, est réalisé en jouant sur plusieurs paramètres tels que l'aimantation à saturation des couches et sa variation thermique, mais aussi les anisotropies d'interface et leur variation thermique, et les anisotropies de volume et leur variation thermique. Le choix des matériaux et de la composition de la couche de surface 2-1 et de la couche de volume 2-2 formant la couche magnétique 2, de la couche tampon 1 et de la couche de contact 4 contribue à modifier tous ces paramètres afin d'ajuster les variations thermiques de l'anisotropie effective et permettre un contrôle en tension sur une large gamme de température.

En général, il est plus facile d'ajuster la variation thermique de l'anisotropie de volume dans le plan afin qu'elle corresponde approximativement à la variation thermique de l'anisotropie de surface perpendiculaire au plan. En effet, il y a plus de paramètres disponibles sur lesquels jouer pour la couche de volume 2-2 que pour la couche de surface 2-1. Dans la plupart des cas, et en particulier lorsque le dispositif 10 est une jonction tunnel magnétique, la couche de surface 2-1 en contact avec la couche isolante non magnétique 3 (qui est, dans le cas d'une jonction tunnel magnétique, une barrière tunnel) est optimisée pour fournir une grande amplitude de magnétorésistance tunnel et une importante variation de l'anisotropie perpendiculaire en fonction de la tension. Il y a cependant une flexibilité limitée dans l'ajustement des propriétés de cette couche. Par opposition, la couche volumique de la couche magnétique 2 est plus librement ajustable, sans modifier les propriétés du dispositif 10 qui sont sensibles à l'interface couche magnétique 2/couche isolante 3.

Toutefois, en ce qui concerne la couche de surface 2-1, plusieurs ajustements sont possibles afin de régler l'amplitude et la variation thermique de l'anisotropie de surface.

- La composition de cette couche de surface 2-1 est variable. Si la couche de surface 2-1 est un alliage de type $(Co_{1-x}Fe_x)_{1-y}B_y$ avec la teneur y en B comprise entre 10% et 25% et la teneur x en Fe comprise entre 80% et 20%, il a été montré que l'amplitude de l'anisotropie perpendiculaire au plan est plus importante avec un alliage riche en Fe qu'avec un alliage riche en Co (voir « First-principles investigation of the very large perpendicular magnetic anisotropy at Fe/MgO and Co/MgO interfaces », Yang H.X. et al., Phys. Rev. B, 84, 054401 (2011)).

- En outre, il est connu que la variation thermique de l'anisotropie de surface rapportée au volume $K_u = \frac{K_{SA}}{t_A + t_B}$ suit une loi de puissance de l'aimantation de la couche ferromagnétique totale, c'est-à-dire ici la couche de volume et la couche de surface. On s'attend à ce que la variation en température de l'anisotropie de surface $K_u$ dépende de l'aimantation spontanée $M_S$ suivant une loi de puissance : $\frac{K_u(T)}{K_u(0)} = \left(\frac{M_S(T)}{M_S(0)}\right)^\eta$. Etant donné que la température de Curie dans le $(Co_{1-x}Fe_x)_{1-y}B_y$ dépend des teneurs relatives en Co et en Fe (la température de Curie du Co est ainsi : $T_{Curie}Co = 1394$ K alors que celle du Fe vaut : $T_{Curie}Fe = 1043$ K), la variation thermique de l'anisotropie de surface peut ainsi être réglée en modifiant les teneurs relatives en Co et en Fe.

- L'épaisseur totale de la couche magnétique totale en contact avec la couche isolante non magnétique 3, c'est-à-dire la somme de l'épaisseur $t_A$ et de l'épaisseur $t_B$, a également une influence sur la variation thermique de l'anisotropie de surface car la variation thermique de l'aimantation dépend de cette épaisseur. En effet, dans les films minces magnétiques, les fluctuations magnétiques ont tendance à se développer plus facilement, ce qui fait que la décroissance thermique de l'aimantation et donc de l'anisotropie est généralement plus prononcée pour les films minces que pour les films épais.

La variation thermique de l'anisotropie de surface est illustrée à titre d'exemple à la figure 10 pour une interface de type Co/AlOx. Pour une telle structure, avec une épaisseur de Co de 2 nm, l'exposant $\eta$ de la formule ci-dessus vaut 1,7. Cet exposant peut varier entre 1,3 et 2,6 pour des épaisseurs de Co allant de 1,3 nm à 2,8 nm. La variation thermique de l'anisotropie de surface peut donc être réglée en fonction de l'épaisseur de Co.

Concernant maintenant la couche de volume 2-2 de la couche magnétique 2, cette couche peut être une couche ferromagnétique simple ou une multicouche composée de plusieurs couches magnétiques et non-magnétiques.

- Dans le cas où on utilise un matériau tel qu'un alliage à base de Co, Fe ou Ni, l'amplitude de l'aimantation et sa décroissance thermique peuvent être ajustées en jouant sur les concentrations relatives de ces divers éléments, mais également en introduisant des éléments additionnels tels que Cr, V, Ta, Cu, Hf, Ti, Nb, Zr, Mo, Zn, Al, Ge, Si. L'incorporation de ces éléments non-magnétiques dans un hôte ferromagnétique permet de diminuer la température de Curie du matériau, ce qui détermine la variation thermique de l'aimantation et donc la variation thermique de l'énergie de démagnétisation, qui est proportionnelle au carré de l'aimantation.
- La couche de volume 2-2 doit être fortement couplée magnétiquement avec la couche de surface 2-1. Le couplage peut être un couplage d'échange direct entre les couches de volume et de surface si elles sont en contact direct. Le couplage peut également être assuré par l'intermédiaire d'une couche mince additionnelle, comme par exemple une couche mince en Ta, en Ti ou en Ru, avec une épaisseur typiquement comprise entre 0,2 nm et 1 nm. Dans le cas où la couche de surface 2-1 est une couche de CoFeB, la couche mince en Ta ou en Ti ou en Ru peut être utilisée afin d'attirer le B à l'écart de la couche isolante non magnétique 3 durant la phase de recuit du dispositif 10. De telles phases de recuit sont courantes dans les dispositifs magnétiques, soit pour définir une direction de référence pour le spin des électrons, soit, dans le cas d'une jonction tunnel magnétique en MgO, pour obtenir une cristallisation correcte de la barrière tunnel et des électrodes ferromagnétiques adjacentes.
- La couche de volume 2-2 peut également comporter des multicouches - en général utilisées pour leur anisotropie perpendiculaire au plan - telle qu'une multicouche de type (Co/Pt), (Co/Cu/Pt), (Co/Pd), (Co/Pt/Ni/Pt), (Co/Pd/Ni/Pd), (Co/Ni), (Cu/Ni). Pour obtenir une anisotropie dans le plan, il faudra alors ajuster plusieurs paramètres : l'épaisseur relative de la couche magnétique, par exemple entre 0,1 et 2 nm, et de la couche non-magnétique, par exemple entre 0,1 et 2 nm, à chaque répétition, ainsi que le nombre de répétition, par exemple entre 1 et 10. Ceci est illustré aux figures 11, 12, 13 et 14.

Par exemple, la figure 11 illustre la variation de l'aimantation en fonction de la température dans plusieurs multicouches de type $Ta_3/Pt_5/(Co_{tCo}/Cu_{0,4}/Pt_{0,4})_5/Cu_2/Pt_2$ dont l'épaisseur de la couche de Co varie. Il ressort clairement de cette figure que la variation thermique de l'aimantation, et de manière corrélative celle de l'anisotropie qui est une loi de puissance de l'aimantation, peut être ajustée en fonction de l'épaisseur de la couche de Co.

De manière similaire, les figures 12 et 13 montrent l'influence de l'épaisseur d'un espaceur non-magnétique sur la décroissance thermique de l'aimantation, respectivement pour des multicouches de $Ta_3/Pt_5/(Co_{0,3}/Pt_{tPt})_5/Cu_2/Pt_2$ en fonction de l'épaisseur de l'espaceur en Pt, et pour des multicouches de $Ta_3/Pd_5/(Co_{0,3}/Pd_{tPd})_5/Cu_2/Pd_2$ en fonction de l'épaisseur de l'espaceur en Pd.

Un autre paramètre qui permet d'ajuster la décroissance thermique de l'anisotropie de volume est le nombre de répétition d'une multicouche, comme illustré à la figure 14. Avec des multicouches de type Co/Pt ou Co/Pd par exemple, la température de transition entre une anisotropie perpendiculaire au plan aux basses températures et dans le plan aux hautes températures peut être réglée avec le nombre n de répétition de la multicouche : (Co/espaceur)n, l'espaceur pouvant désigner du Pt ou du Pd. Par exemple pour deux répétitions de Co/Pt, la transition est obtenue à 130°C, alors que pour cinq répétitions de Co/Pt elle peut aller jusqu'à 250°C. Pour les multicouches de Co/Pd, cette température de transition est réputée varier en fonction du nombre de répétition mais également en fonction de l'épaisseur de la couche de Co : pour trois répétitions, la température de transition passe de 130°C à 190°C lorsque l'épaisseur de la couche de Co passe de 0,2 nm à 0,3 nm.

La composition chimique de la couche de volume 2-2 peut également être ajustée afin de régler la décroissance thermique de l'anisotropie de la couche de volume 2-2 de la couche magnétique 2. Par exemple, les multicouches de type (Co/Pt/Ni/Pt) présentent une décroissance de leur anisotropie en fonction de la température plus rapide que les multicouches de (Co/Pt) à épaisseur similaire de matériau magnétique (Co, Ni) et à épaisseur similaire de matériau non magnétique. Ceci est documenté par exemple dans la publication « Magnetic and magneto-optical properties of (Pt/Co/Pt/Ni) multilayers », de G. Srinivas et al., Thin Solid Films 301, 211-216 (1997).

La couche de volume 2-2 peut également comprendre un alliage avec une structure tétragonale $L1_0$, comme par exemple un alliage de FePt, FePd, FeNiPt, FeNiPd, FeCuPt ou FeCuPd. Lorsque la distorsion tétragonale est orientée hors plan, ces alliages ont une anisotropie perpendiculaire due à l'anisotropie magnéto-cristalline, qui dans ce cas ne peut plus être négligée par rapport à l'anisotropie de forme, et peuvent donc contribuer à l'obtention d'une anisotropie totale de l'empilement perpendiculaire au plan. La substitution de certains éléments de Fe par du Ni ou du Cu permet de diminuer la température de Curie de l'alliage.

Il est donc possible d'intervenir sur un grand nombre de paramètres, à la fois pour la couche de surface 2-1 et pour la couche de volume 2-2 de la couche magnétique 2, afin que les variations thermiques des anisotropies de surface et de volume diffèrent suffisamment peu l'une de l'autre pour que l'application d'une tension de polarisation $V_{max}$ permette, sur une gamme de température de fonctionnement souhaitée, la transition de l'anisotropie effective $K_{eff}$ d'une direction perpendiculaire au plan de référence à une direction dans le plan de référence ou inversement. La couche de volume 2-2, de part notamment sa composition et son épaisseur, est utilisée pour régler l'anisotropie de volume et les variations thermiques de l'anisotropie de volume tandis que la couche de surface 2-1 est utilisée pour régler l'anisotropie de surface et les variations thermiques de l'anisotropie de surface.

En résumé, dans ce premier mode de réalisation, l'anisotropie de surface $K_{SA}$ et les anisotropies de volume $K_{VA}$ et $K_{VB}$ respectent donc, sur une gamme de température souhaitée, l'équation suivante :

$$0 < K_{SA}(V = V_{max}) < -(K_{VB}t_B + K_{VA}t_A) < K_{SA}(V = 0)$$

Selon un deuxième mode de réalisation :

- l'anisotropie de surface $K_{SA}$ est dans une direction perpendiculaire au plan et les première et deuxième anisotropies de volume $K_{VB}$ et $K_{VA}$ sont dans une direction dans le plan ;
- l'anisotropie effective $K_{eff}$ est dans une direction dans le plan lorsqu'aucune tension de polarisation n'est appliquée et dans une direction perpendiculaire au plan lorsqu'une tension de polarisation $V_{max}$ est appliquée.

Pour ce deuxième mode de réalisation :

- la couche isolante non magnétique 3 peut être réalisée en MgO, AlOx, AlN, $SrTiO_3$, HfOx, TaOx ou tout autre oxyde ou nitride isolant ;
- la couche de surface 2-1, d'épaisseur $t_A$, peut être un alliage à base de Co, de Fe ou de Ni, ou de tout autre matériau conduisant, en combinaison avec la couche isolante non magnétique 3, à une anisotropie de surface perpendiculaire et présentant une importante variation en fonction de l'application ou non d'un champ électrique. Si le dispositif 10 est une jonction tunnel magnétique, alors la couche de surface 2-1 doit également fournir une importante magnétorésistance ;
- la couche de volume 2-2, d'épaisseur $t_B$, peut être :

  ◦ une multicouche avec une anisotropie de volume dans le plan, composée de n répétitions d'une bicouche de type F1 /N1, d'une bicouche de type F1/F2 ou d'une quadricouche de type F1/N1/F2/N2, où F1 et F2 sont deux matériaux ferromagnétiques, comme par exemple Fe, Co, Ni, Gd et leurs alliages, et N1 et N2 sont deux matériaux non magnétiques, comme par exemple Cu, Cr, Ta, Ti, Hf, Mo, Ag, Au, Pd, Pt ;
  ◦ une couche simple avec une anisotropie de volume dans le plan, réalisée dans un alliage tel que du FePt, FePd, FeNiPt, FeNiPd, FeCuPt ou FeCuPd, présentant une structure tétragonale $L1_0$ avec une distorsion tétragonale orientée dans le plan, c'est-à-dire avec un axe de facile aimantation orienté dans le plan ;
  ◦ une couche simple avec une anisotropie de volume dans le plan, réalisée dans un alliage de type F1F2F3N1N2, où F1, F2 et F3 sont trois matériaux ferromagnétiques, par exemple du Fe, Co, Ni, Gd et leurs alliages, et N1 et N2 sont deux matériaux non magnétiques, par exemple du Cr, Ta, Cu, Hf, Ti, Nb, Zr, Mo, Ag, Au, Pd, Pt.

Des exemples d'alliages possibles sont ainsi : CoCr, CoCrPt, CoCrTa, FeNiTa, CoFeCrPt. L'intérêt du dopage non magnétique est de réduire l'anisotropie de volume dans le plan afin d'avoir une anisotropie effective $K_{eff}$ suffisamment proche de zéro et pouvoir changer son signe grâce à l'application d'un champ électrique ;

- l'épaisseur $t_B$ de la couche de volume 2-2 est choisie suffisamment importante pour que, lorsqu'aucune tension de polarisation n'est appliquée, l'anisotropie de volume dans le plan l'emporte sur l'anisotropie de surface perpendiculaire au plan, conduisant à une anisotropie effective $K_{eff}$ dans le plan lorsqu'aucune tension de polarisation n'est appliquée.

En résumé, l'anisotropie de surface $K_{SA}$ et les première et deuxième anisotropies de volume $K_{VB}$ et $K_{VA}$ respectent donc, sur une gamme de fonctionnement souhaitée, l'inéquation suivante :

$$0 < K_{SA}(V = 0) < -(K_{VB}t_B + K_{VA}t_A) < K_{SA}(V = V_{max})$$

avec $K_{SA}$(V=0) l'anisotropie de surface lorsqu'aucune tension de polarisation n'est appliquée et $K_{SA}$(V=$V_{max}$) l'anisotropie de surface lorsqu'une tension de polarisation $V_{max}$ est appliquée.
Selon un troisième mode de réalisation :

- l'anisotropie de surface $K_{SA}$ est dans une direction dans le plan et les première et deuxième anisotropies de volume $K_{VB}$ et $K_{VA}$ sont dans une direction perpendiculaire au plan ;
- l'anisotropie effective $K_{eff}$ est dans une direction perpendiculaire au plan lorsqu'aucune tension de polarisation n'est appliquée et dans une direction dans le plan lorsqu'une tension de polarisation $V_{max}$ est appliquée.

Pour ce troisième mode de réalisation :

- la couche isolante non magnétique 3 peut être réalisée en MgO, AlOx, AlN, SrTiO$_3$, HfOx, TaOx ou tout autre oxyde ou nitride isolant et ayant une teneur en oxygène et/ou nitrogène interfacial telle qu'une anisotropie de surface dans le plan est assurée ;
- la couche de surface 2-1, d'épaisseur $t_A$, peut être un alliage à base de Co, de Fe ou de Ni, ou de tout autre matériau conduisant, en combinaison avec la couche isolante non magnétique 3, à une anisotropie de surface dans le plan et présentant une importante variation en fonction de l'application ou non d'un champ électrique. Par exemple, les interfaces de type CoFeB/MgO peuvent fournir une anisotropie de surface dans le plan si la couche isolante en MgO est suroxydée, de manière que certains éléments d'oxygène pénètrent un peu dans la première couche atomique de CoFeB au contact de la couche de MgO. Si le dispositif 10 est une jonction tunnel magnétique, alors la couche de surface 2-1 doit également fournir une importante magnétorésistance ;
- la couche de volume 2-2, d'épaisseur $t_B$, peut être :

  ◦ une multicouche avec une anisotropie de volume perpendiculaire au plan, composée de n répétitions d'une bicouche de type F1 /N1, d'une bicouche de type F1/F2 ou d'une quadricouche de type F1/N1/F2/N2, où F1 et F2 sont deux matériaux ferromagnétiques, et N1 et N2 sont deux matériaux paramagnétiques. Des exemples de bicouches possibles sont : Co/Pt, Co/Pd, Co/Ni, Co/Au, Ni/Cu ;
  ◦ une couche simple avec une anisotropie de volume perpendiculaire au plan, réalisée dans un alliage tel que du FePt, FePd, FeNiPt, FeNiPd, FeCuPt ou FeCuPd, présentant une structure tétragonale L1$_0$ avec un axe de facile aimantation orienté perpendiculairement au plan ;
  ◦ une couche simple avec une anisotropie de volume perpendiculaire au plan, réalisée dans un alliage de type F1F2F3N1N2, où F1, F2 et F3 sont trois matériaux ferromagnétiques, et N1 et N2 sont deux matériaux paramagnétiques. Des exemples d'alliages possibles sont : CoCr, CoCrPt, dans lesquels l'axe de facile aimantation est orienté perpendiculairement au plan ;

- l'épaisseur $t_B$ de la couche de surface 2-2 est choisie suffisamment importante pour que, lorsqu'aucune tension de polarisation n'est appliquée, l'anisotropie de volume perpendiculaire au plan l'emporte sur l'anisotropie de surface dans le plan, conduisant à une anisotropie effective $K_{eff}$ perpendiculaire au plan lorsqu'aucune tension de polarisation n'est appliquée.

En résumé, l'anisotropie de surface $K_{SA}$ et les première et deuxième anisotropies de volume $K_{VB}$ et $K_{VA}$ respectent donc, sur une gamme de fonctionnement souhaitée, l'inéquation suivante :

$$K_{SA}(V = V_{max}) < -(K_{VB}t_B + K_{VA}t_A) < K_{SA}(V = 0) < 0$$

avec $K_{SA}(V=0)$ l'anisotropie de surface lorsqu'aucune tension de polarisation n'est appliquée et $K_{SA}(V=V_{max})$ l'anisotropie de surface lorsqu'une tension de polarisation $V_{max}$ est appliquée.

Selon un quatrième mode de réalisation :

- l'anisotropie de surface $K_{SA}$ est dans une direction dans le plan et les première et deuxième anisotropies de volume $K_{VB}$ et $K_{VA}$ sont dans une direction perpendiculaire au plan ;
- l'anisotropie effective $K_{eff}$ est dans une direction dans le plan lorsqu'aucune tension de polarisation n'est appliquée et dans une direction perpendiculaire au plan lorsqu'une tension de polarisation $V_{max}$ est appliquée.

Pour ce quatrième mode de réalisation :

- la couche isolante non magnétique 3 peut être réalisée en MgO, AlOx, AlN, $SrTiO_3$, HfOx, TaOx ou tout autre oxyde ou nitride isolant et ayant une teneur en oxygène et/ou nitrogène interfacial telle qu'une anisotropie de surface dans le plan est assurée ;
- la couche de surface 2-1, d'épaisseur $t_A$, peut être un alliage à base de Co, de Fe ou de Ni, ou de tout autre matériau conduisant, en combinaison avec la couche isolante non magnétique 3, à une anisotropie de surface dans le plan et présentant une importante variation en fonction de l'application ou non d'un champ électrique. Par exemple, les interfaces de type CoFeB/MgO peuvent fournir une anisotropie de surface dans le plan si la couche isolante en MgO est suroxydée, de manière que certains éléments d'oxygène pénètrent un peu dans la première couche atomique de CoFeB au contact de la couche de MgO. Si le dispositif 10 est une jonction tunnel magnétique, alors la couche de surface 2-1 doit également fournir une importante magnétorésistance ;

- la couche de volume 2-2, d'épaisseur $t_B$, peut être :

  ◦ une multicouche avec une anisotropie de volume perpendiculaire au plan, composée de n répétitions d'une bicouche de type F1 /N1, d'une bicouche de type F1/F2 ou d'une quadricouche de type F1/N1/F2/N2, où F1 et F2 sont deux matériaux ferromagnétiques, et N1 et N2 sont deux matériaux paramagnétiques. Des exemples de bicouches possibles sont : Co/Pt, Co/Pd, Co/Ni, Co/Au, Ni/Cu ;
  ◦ une couche simple avec une anisotropie de volume perpendiculaire au plan, réalisée dans un alliage tel que du FePt, FePd, FeNiPt, FeNiPd, FeCuPt ou FeCuPd, présentant une structure tétragonale $L1_0$ avec un axe de facile aimantation orienté perpendiculairement au plan ;
  o une couche simple avec une anisotropie de volume perpendiculaire au plan, réalisée dans un alliage de type F1 F2F3N1 N2, où F1, F2 et F3 sont trois matériaux ferromagnétiques, et N1 et N2 sont deux matériaux paramagnétiques. Des exemples d'alliages possibles sont : CoCr, CoCrPt, dans lesquels l'axe de facile aimantation est orienté perpendiculairement au plan ;

- l'épaisseur $t_B$ de la couche de surface 2-2 est choisie suffisamment mince pour que, lorsqu'aucune tension de polarisation n'est appliquée, l'anisotropie de surface dans le plan l'emporte sur l'anisotropie de volume perpendiculaire au plan, conduisant à une anisotropie effective $K_{eff}$ dans le plan lorsqu'aucune tension de polarisation n'est appliquée.

En résumé, l'anisotropie de surface $K_{SA}$ et les première et deuxième anisotropies de volume $K_{VB}$ et $K_{VA}$ respectent donc, sur une gamme de fonctionnement souhaitée, l'inéquation suivante :

$$K_{SA}(V = 0) < -(K_{VB}t_B + K_{VA}t_A) < K_{SA}(V = V_{max}) < 0$$

avec $K_{SA}(V=0)$ l'anisotropie de surface lorsqu'aucune tension de polarisation n'est appliquée et $K_{SA}(V=V_{max})$ l'anisotropie de surface lorsqu'une tension de polarisation $V_{max}$ est appliquée.

**Revendications**

**1.** Dispositif (10) magnétique contrôlé en tension comportant :

- une couche magnétique (2) s'étendant suivant un plan de référence et présentant une aimantation à direction variable et une anisotropie effective $K_{eff}$ ;
- une couche isolante non magnétique (3) s'étendant sur la couche magnétique ;
- une couche de contact (4) s'étendant sur la couche isolante ;
- un moyen d'application d'une tension de polarisation entre la couche de contact (4) et la couche magnétique (2), à travers la couche isolante non magnétique (3) ; **caractérisé en ce que** la ladite couche magnétique (2) présentant un seuil de basculement d'anisotropie tel que l'application d'une tension de polarisation $V_{max}$ à travers la couche isolante permet le basculement de l'anisotropie effective $K_{eff}$ d'une direction perpendiculaire au plan de référence à une direction dans le plan de référence ou inversement,

ledit dispositif (10) magnétique étant **caractérisé en ce que** la couche magnétique comporte :

- une première couche (2-2), dite « couche de volume », d'épaisseur $t_B$, présentant une première anisotropie de volume $K_{VB}$ ;
- une deuxième couche (2-1), dite «couche de surface », d'épaisseur $t_A$, présentant une anisotropie de surface $K_{SA}$ et une deuxième anisotropie de volume $K_{VA}$, la couche de surface (2-1) se trouvant entre la couche de volume (2-2) et la couche isolante non magnétique (3) ;

la composition et l'épaisseur des couches de surface (2-1) et de volume (2-2) étant choisies afin que l'anisotropie de surface $K_{SA}$ et les première et deuxième anisotropies de volume $K_{VB}$ et $K_{VA}$ respectent, sur une gamme de fonctionnement en température donnée, l'inéquation suivante :

$$Min\big(K_{SA}(V = 0), K_{SA}(V = V_{max})\big) < -(K_{VB}t_B + K_{VA}t_A)$$
$$< Max\big(K_{SA}(V = 0), K_{SA}(V = V_{max})\big)$$

où $K_{SA}(V=0)$ est l'anisotropie de surface lorsqu'aucune tension de polarisation n'est appliquée ; $K_{SA}(V=V_{max})$ est l'anisotropie de surface lorsque la tension de polarisation $V_{max}$ est appliquée.

2. Dispositif (10) magnétique selon la revendication 1 **caractérisé en ce que** la couche isolante (3) est réalisée en MgO, AlOx, AlN, $SrTiO_3$, HfOx ou tout autre oxyde ou nitride isolant présentant une polarisabilité diélectrique supérieure ou égale à 6.

3. Dispositif (10) magnétique selon l'une quelconque des revendications précédentes **caractérisé en ce que** :

- l'anisotropie effective $K_{eff}$ est dans une direction perpendiculaire au plan de référence lorsqu'aucune tension de polarisation n'est appliquée ;
- l'anisotropie effective $K_{eff}$ est dans une direction dans le plan de référence lorsque la tension de polarisation $V_{max}$ est appliquée.

4. Dispositif (10) magnétique selon la revendication 3 **caractérisé en ce que** :

- l'anisotropie de surface $K_{SA}$ de la couche de surface (2-1) est dans une direction perpendiculaire au plan de référence et l'anisotropie de surface $K_{SA}$ décroît lorsqu'on applique la tension de polarisation $V_{max}$ ;
- l'anisotropie de volume totale $K_{VB}t_B+K_{VA}t_A$ est dans une direction dans le plan de référence.

5. Dispositif (10) magnétique selon la revendication 3 **caractérisé en ce que** :

- l'anisotropie de surface $K_{SA}$ de la couche de surface (2-1) est dans une direction dans le plan de référence et l'anisotropie de surface $K_{SA}$ croît lorsqu'on applique la tension de polarisation $V_{max}$ ;
- l'anisotropie de volume totale $K_{VB}t_B+K_{VA}t_A$ est dans une direction perpendiculaire au plan de référence.

6. Dispositif (10) magnétique selon l'une quelconque des revendications 1 ou 2 **caractérisé en ce que** :

- l'anisotropie effective $K_{eff}$ est dans une direction dans le plan de référence lorsqu'aucune tension de polarisation n'est appliquée ;
- l'anisotropie effective $K_{eff}$ est dans une direction perpendiculaire au plan de référence lorsque la tension de

polarisation $V_{max}$ est appliquée.

**7.** Dispositif (10) magnétique selon la revendication 6 **caractérisé en ce que** :

- l'anisotropie de surface $K_{SA}$ de la couche de surface (2-1) est dans une direction perpendiculaire au plan de référence et l'anisotropie de surface $K_{SA}$ croît lorsqu'on applique la tension de polarisation $V_{max}$ ;

l'anisotropie de volume totale $K_{VB}t_B + K_{VA}t_A$ est dans une direction dans le plan de référence.

**8.** Dispositif (10) magnétique selon la revendication 6 **caractérisé en ce que** :

- l'anisotropie de surface $K_{SA}$ de la couche de surface (2-1) est dans une direction dans le plan de référence et l'anisotropie de surface $K_{SA}$ décroît lorsqu'on applique la tension de polarisation $V_{max}$ ;
- l'anisotropie de volume totale $K_{VB}t_B + K_{VA}t_A$ est dans une direction perpendiculaire au plan de référence.

**9.** Dispositif (10) magnétique selon l'une quelconque des revendications 4 ou 7 **caractérisé en ce que** la couche de surface (2-1) est réalisée avec un alliage à base de Co, Fe, Ni ou tout autre matériau conduisant, en combinaison avec la couche isolante (3), à une anisotropie de surface $K_{SA}$ perpendiculaire au plan de référence et présentant une variation supérieure à 5 % en fonction de l'application ou non de la tension de polarisation $V_{max}$.

**10.** Dispositif (10) magnétique selon l'une quelconque des revendications 1 ou 2 **caractérisé en ce que** la couche de volume (2-2) présentant la première anisotropie de volume $K_{VB}$ est un empilement multicouche de n motifs élémentaires de type F1/N1 ou F1/N1/F2/N2 ou F1/F2, avec F1 et F2 deux matériaux ferromagnétiques différents et N1 et N2 deux matériaux non magnétiques différents.

**11.** Dispositif (10) magnétique selon l'une quelconque des revendications 1 ou 2 **caractérisé en ce que** la couche de volume (2-2) présentant la première anisotropie de volume $K_{VB}$ est un alliage présentant une structure tétragonale $L1_0$.

**12.** Dispositif (10) magnétique selon l'une quelconque des revendications 1 ou 2 **caractérisé en ce que** la couche de volume (2-2) présentant la première anisotropie de volume $K_{VB}$ est une monocouche d'un alliage de type F1F2F3N1N2, avec F1, F2 et F3 trois matériaux ferromagnétiques différents et N1 et N2 deux matériaux non magnétiques différents.

**13.** Dispositif (10) magnétique selon l'une quelconque des revendications précédentes **caractérisé en ce que** :

- la couche de contact (4) comporte, au contact de la couche isolante non magnétique (3), une couche magnétique présentant une direction d'aimantation fixe servant de direction de référence pour l'aimantation ;
- la couche isolante non magnétique (3) est une barrière tunnel permettant à un courant de circuler par effet tunnel entre la couche de contact (4) et la couche magnétique (2) ;

le dispositif (10) se comportant alors comme une jonction tunnel magnétique.

**14.** Dispositif (10) magnétique selon la revendication précédente **caractérisé en ce que** :

- la couche magnétique de la couche de contact (4) est un alliage de CoFeB;
- la couche isolante non magnétique (3) est réalisée en MgO ;
- la couche de surface (2-1) de la couche magnétique (2) est un alliage de CoFeB.

**Patentansprüche**

**1.** Spannungskontrollierte, magnetische Vorrichtung (10), umfassend:

- eine magnetische Schicht (2), die sich gemäß einer Referenzebene erstreckt und eine Magnetisierung mit variabler Richtung und eine effektive Anisotropie $K_{eff}$ umfasst;
- eine nicht magnetische, isolierende Schicht (3), die sich auf der magnetischen Schicht erstreckt;
- eine Kontaktschicht (4), die sich auf der isolierenden Schicht erstreckt;

- ein Anwendungsmittel einer Polarisationsspannug zwischen der Kontaktschicht (4) und der magnetischen Schicht (2) durch die nicht magnetische isolierende Schicht (3);

**dadurch gekennzeichnet, dass**

die genannte magnetische Schicht (2) einen Umschalt-Schwellenwert der Anisotropie derart aufweist, dass die Anwendung eine Polarisationsspannung $V_{max}$ durch die isolierende Schicht das Umschalten der effektiven Anisotropie $K_{eff}$ einer zur Referenzebene lotrechten Richtung in eine Richtung in der Referenzebene oder umgekehrt aufweist;

wobei die genannte magnetische Vorrichtung (10) **dadurch gekennzeichnet ist, dass** die magnetische Schicht umfasst:

- eine erste Schicht (2-2), bezeichnet als "Volumenschicht" mit einer Dicke $t_B$, die eine erste Volumen-Anisotropie $K_{VB}$ aufweist;
- eine zweite Schicht (2-1), bezeichnet als "Oberflächenschicht" mit einer Dicke $t_A$, die eine Oberflächen-Anisotropie $K_{SA}$ und eine zweite Volumenanisotropie $K_{VA}$ aufweist, wobei die Oberflächenschicht (2-1) sich zwischen der Volumenschicht (2-2) und der nicht magnetischen isolierenden Schicht (3) befindet;

wobei die Zusammensetzung und die Dicke der Oberflächen- (2-1) und Volumenschichten (2-2) ausgewählt sind, damit die Oberflächen-Anisotropie $K_{SA}$ und die erste und zweite Volumen-Anisotropie $K_{VB}$ und $K_{VA}$ in einem vorgegebenen Funktionsbereich der Temperatur, die folgende Ungleichung einhalten:

$$Min\big(K_{SA}(V=0), K_{SA}(V=V_{max})\big) < -(K_{VB}t_B + K_{VA}t_A)$$
$$< Max\big(K_{SA}(V=0), K_{SA}(V=V_{max})\big)$$

wobei ($K_{SA}$ (V = 0) die Oberflächen-Anisotropie ist, wenn keine Polarisationsspannung angewendet wird; $K_{SA}$ (V = $V_{max}$) die Oberflächen-Anisotropie ist, wenn die Polarisationsspannung $V_{max}$ angewendet ist.

2. Magnetische Vorrichtung (10) gemäß Anspruch 1, **dadurch gekennzeichnet, dass** die isolierende Schicht (3) aus MgO, AlOx, AlN, $SrTiOx_3$, HfOx oder jedem anderen isolierenden Oxid oder Nitrid realisiert ist, das eine dielektrische Polarisationsfähigkeit größer als oder gleich 6 aufweist.

3. Magnetische Vorrichtung (10) gemäß irgendeinem der voranstehenden Ansprüche, **dadurch gekennzeichnet, dass**:

   - die effektive Anisotropie $K_{eff}$ in einer zur Referenzebene lotrechten Richtung ist, wenn keine Polarisationsspannung angewendet ist;
   - die effektive Anisotropie $K_{eff}$ in einer Richtung in der Referenzebene ist, wenn die Polarisationsspannung $V_{max}$ angewendet ist.

4. Magnetische Vorrichtung (10) gemäß Anspruch 3, **dadurch gekennzeichnet, dass**:

   - die Oberflächen-Anisotropie $K_{SA}$ der Oberflächenschicht (2-1) in einer zur Referenzebene lotrechten Richtung ist und die Oberflächen-Anisotropie $K_{SA}$ abnimmt, wenn die Polarisationsspannung $V_{max}$ angewendet ist;
   - die totale Volumenanisotropie $K_{VB}t_B + K_{VA}t_A$ in einer Richtung in der Referenzebene ist.

5. Magnetische Vorrichtung (10) gemäß Anspruch 3, **dadurch gekennzeichnet, dass**:

   - die Oberflächen-Anisotropie $K_{SA}$ der Oberflächenschicht (2-1) in einer Richtung in der Referenzebene ist und die Oberflächen-Anisotropie $K_{SA}$ zunimmt, wenn die Polarisationsspannung $V_{max}$ angewendet ist;
   - die totale Volumen-Anisotropie $K_{VB}t_B + K_{VA}t_A$ in einer zur Referenzebene lotrechten Richtung ist.

6. Magnetische Vorrichtung (10) gemäß irgendeinem der Ansprüche 1 oder 2, **dadurch gekennzeichnet, dass**:

   - die effektive Anisotropie $K_{eff}$ in einer Richtung in der Referenzebene ist, wenn keine Polarisationsspannung angewendet ist;
   - die effektive Anisotropie $K_{eff}$ in einer zur Referenzebene lotrechten Richtung ist, wenn die Polarisationsspan-

nung $V_{max}$ angewendet ist.

7. Magnetische Vorrichtung (10) gemäß Anspruch 6, **dadurch gekennzeichnet, dass**:

- die Oberflächen-Anisotropie $K_{SA}$ der Oberflächenschicht (2-1) in einer zur Referenzebene lotrechten Richtung ist und die Oberflächen-Anisotropie $K_{SA}$ zunimmt, wenn die Polarisationsspannung $V_{max}$ angewendet ist;
- die totale Volumen-Anisotropie $K_{VB}t_B+K_{VA}t_A$ in einer Richtung in der Referenzebene ist.

8. Magnetische Vorrichtung (10) gemäß Anspruch 6, **dadurch gekennzeichnet, dass**:

- die Oberflächen-Anisotropie $K_{SA}$ der Oberflächenschicht (2-1) in einer Richtung in der Referenzebene ist und die Oberflächen-Anisotropie $K_{SA}$ abnimmt, wenn die Polarisationsspannung $V_{max}$ angewendet ist;
- die totale Volumen-Anisotropie $K_{VB}t_B+K_{VA}t_A$ in einer zur Referenzebene lotrechten Richtung ist.

9. Magnetische Vorrichtung (10) gemäß irgendeinem der Ansprüche 4 oder 7, **dadurch gekennzeichnet, dass** die Oberflächenschicht (2-1) mit einer Legierung basierend auf Co, Fe, Ni oder jedem anderen Material in Kombination mit der isolierenden Schicht (3), die zu einer zur Referenzebene lotrechten und einer in Abhängigkeit von der Anwendung oder Nicht-Anwendung der Polarisationsspannung $V_{max}$ aufweisenden Variation von mehr als 5 % aufweisenden Oberflächen-Anisotropie $K_{SA}$ führt, realisiert ist.

10. Magnetische Vorrichtung (10) gemäß irgendeinem der Ansprüche 1 oder 2, **dadurch gekennzeichnet, dass** die Volumenschicht (2-2), die die erste Volumen-Anisotropie $K_{VB}$ aufweist, eine mehrschichtige Stapelung von n elementaren Motiven vom Typ F1/N1 oder F1/N1/F2/N2 oder F1/F2 ist, wobei F1 und F2 zwei unterschiedliche ferromagnetische Materialien und N1 und N2 zwei unterschiedliche nicht magnetische Materialien sind.

11. Magnetische Vorrichtung (10) gemäß irgendeinem der Ansprüche 1 oder 2, **dadurch gekennzeichnet, dass** die Volumenschicht (2-2), die die erste Volumen-Anisotropie $K_{BV}$ aufweist, eine Legierung ist, die eine tetragonale Struktur $L1_0$ aufweist.

12. Magnetische Vorrichtung (10) gemäß irgendeinem der Ansprüche 1 oder 2, **dadurch gekennzeichnet, dass** die Volumenschicht (2-2), die die erste Volumen-Anisotropie $K_{VB}$ aufweist, eine einschichtige Schicht einer Legierung vom Typ F1 F2F3N1 N2 ist, wobei F1, F2 und F3 drei unterschiedliche ferromagnetische Materialien sind und N1 und N2 zwei unterschiedliche nicht magnetische Materialien sind.

13. Magnetische Vorrichtung (10) gemäß irgendeinem der voranstehenden Ansprüche, **dadurch gekennzeichnet, dass**:

- die Kontaktschicht (4) beim Kontakt mit der nicht magnetischen isolierenden Schicht (3) eine magnetische Schicht umfasst, die eine feste Magnetisierungsrichtung aufweist, die als Referenzrichtung für die Magnetisierung dient;
- die nicht magnetische isolierende Schicht (3) eine Tunnelbarriere ist, die dem Strom das Fließen per Tunneleffekt zwischen der Kontaktschicht (4) und der magnetischen Schicht (2) erlaubt;
- wobei sich die Vorrichtung (10) dann wie eine magnetische Tunnelverbindung verhält.

14. Magnetische Vorrichtung (10) gemäß dem voranstehenden Anspruch, **dadurch gekennzeichnet, dass**:

- die magnetische Schicht der Kontaktschicht (4) eine Legierung aus CoFeB ist;
- die nicht magnetische isolierende Schicht (3) aus MgO realisiert ist;
- die Oberflächenschicht (2-1) der magnetischen Schicht (2) eine Legierung aus CoFeB ist.

**Claims**

1. A voltage-controlled magnetic device (10) comprising:

- a magnetic layer (2) extending along a reference plane and having a variable-direction magnetisation and an effective anisotropy $K_{eff}$;
- a non-magnetic insulating layer (3) extending on the magnetic layer;

- a contact layer (4) extending on the insulating layer;
- a means for applying a bias voltage between the contact layer (4) and the magnetic layer (2), through the non-magnetic insulating layer (3);

**characterised by**
said magnetic layer (2) having an anisotropy switching threshold such that applying a bias voltage $V_{max}$ through the insulating layer enables switching the effective anisotropy $K_{eff}$ from a direction perpendicular to the reference plane to a direction in the reference plane or vice versa,
said magnetic device (10) being **characterised in that** the magnetic layer comprises:

- a first layer (2-2), referred to as the "volume layer", of a thickness $t_B$, having a first volume anisotropy $K_{VB}$;
- a second layer (2-1), referred to as the "surface layer", of a thickness $t_A$, having a surface anisotropy $K_{SA}$ and a second volume anisotropy $K_{VA}$, the surface layer (2-1) lying between the volume layer (2-2) and the non-magnetic insulating layer (3);

the composition and thickness of the surface (2-1) and volume (2-2) layers being selected in order for the surface anisotropy $K_{SA}$ and the first and second volume anisotropies $K_{VB}$ and $K_{VA}$ to meet, over a given temperature operating range, the following inequation:

$$Min\big(K_{SA}(V = 0), K_{SA}(V = V_{max})\big) < -(K_{VB}t_B + K_{VA}t_A)$$
$$< Max\big(K_{SA}(V = 0), K_{SA}(V = V_{max})\big)$$

where $K_{SA}(V = 0)$ is the surface anisotropy when no bias voltage is applied; $K_{SA}(V = V_{max})$ is the surface anisotropy when the bias voltage $V_{max}$ is applied.

2. The magnetic device (10) according to claim 1, **characterised in that** the insulating layer (3) is made of MgO, AlOx, AlN, $SrTiO_3$, HfOx or any other insulating oxide or nitride having a dielectric polarisability equal to or greater than 6.

3. The magnetic device (10) according to any of the preceding claims, **characterised in that**:

- the effective anisotropy $K_{eff}$ is in a direction perpendicular to the reference plane when no bias voltage is applied;
- the effective anisotropy $K_{eff}$ is in a direction in the reference plane when the bias voltage $V_{max}$ is applied.

4. The magnetic device (10) according to claim 3, **characterised in that**:

- the surface anisotropy $K_{SA}$ of the surface layer (2-1) is in a direction perpendicular to the reference plane and the surface anisotropy $K_{SA}$ decreases when the bias voltage $V_{max}$ is applied;
- the total volume anisotropy $K_{VB}T_B + K_{VA}t_A$ is in a direction in the reference plane.

5. The magnetic device (10) according to claim 3, **characterised in that**:

- the surface anisotropy $K_{SA}$ of the surface layer (2-1) is in a direction in the reference plane and the surface anisotropy $K_{SA}$ increases when the bias voltage $V_{max}$ is applied;
- the total volume anisotropy $K_{VB}T_B + K_{VA}t_A$ is in a direction perpendicular to the reference plane.

6. The magnetic device (10) according to any of claims 1 or 2, **characterised in that**:

- the effective anisotropy $K_{eff}$ is in a direction in the reference plane when no bias voltage is applied;
- the effective anisotropy $K_{eff}$ is in a direction perpendicular to the reference plane when the bias voltage $V_{max}$ is applied.

7. The magnetic device (10) according to claim 6, **characterised in that**:

- the surface anisotropy $K_{SA}$ of the surface layer (2-1) is in a direction perpendicular to the reference plane and the surface anisotropy $K_{SA}$ increases when the bias voltage $V_{max}$ is applied;
- the total volume anisotropy $K_{VB}T_B + K_{VA}t_A$ is in a direction in the reference plane.

8. The magnetic device (10) according to claim 6, **characterised in that**:

   - the surface anisotropy $K_{SA}$ of the surface layer (2-1) is in a direction in the reference plane and the surface anisotropy $K_{SA}$ decreases when the bias voltage $V_{max}$ is applied;
   - the total volume anisotropy $K_{VB}T_B + K_{VA}t_A$ is in a direction perpendicular to the reference plane.

9. The magnetic device (10) according to any of claims 4 or 7, **characterised in that** the surface layer (2-1) is made with a Co, Fe, Ni based alloy or any other material leading to, in combination with the insulating layer (3), a surface anisotropy $K_{SA}$ perpendicular to the reference plane and having a variation greater than 5% depending on whether the bias voltage $V_{max}$ is applied or not.

10. The magnetic device (10) according to any of claims 1 or 2, **characterised in that** the volume layer (2-2) having the first volume anisotropy $K_{VB}$ is a multilayer stack of n elementary patterns of type F1/N1 or F1/N1/F2/N2 or F1/F2, with F1 and F2 being two different ferromagnetic materials and N1 and N2 being two different non-magnetic materials.

11. The magnetic device (10) according to any of claims 1 or 2, **characterised in that** the volume layer (2-2) having the first volume anisotropy $K_{VB}$ is an alloy having a tetragonal structure $L1_0$.

12. The magnetic device (10) according to any of claims 1 or 2, **characterised in that** the volume layer (2-2) having the first volume anisotropy $K_{VB}$ is a monolayer of an F1F2F3N1N2 type alloy, with F1, F2 and F3 being three different ferromagnetic materials and N1 and N2 being two different non-magnetic materials.

13. The magnetic device (10) according to any of the preceding claims, **characterised in that**:

   - the contact layer (4) includes, in contact with the non-magnetic insulating layer (3), a magnetic layer having a fixed magnetisation direction acting as a reference direction for magnetisation;
   - the non-magnetic insulating layer (3) is a tunnel barrier enabling a current to flow by tunnel effect between the contact layer (4) and the magnetic layer (2);

   the device (10) thus behaving as a magnetic tunnel junction.

14. The magnetic device (10) according to the previous claim, **characterised in that**:

   - the magnetic layer of the contact layer (4) is a CoFeB alloy;
   - the non-magnetic insulating layer (3) is made of MgO;
   - the surface layer (2-1) of the magnetic layer (2) is a CoFeB alloy.

**Fig. 1a**

**Fig. 1b**

**Fig. 1c**

**Fig. 1d**

**Fig. 1e**

**Fig. 1f**

$K_{S1}+K_{S2}$

Pente $-0.5\mu_0 M_s^2+K_v$

Hors du plan

0     $t_F$

Dans le plan

**Fig. 2**

$K_{eff} \cdot t_F$

$K_{S1}+K_{S2}(V=0)$

$K_{S1}+K_{S2}(V=V_{max})$

31

Aimantation
hors du plan à V=0

Hors du plan

0     $t_F$

$t_C$

Dans le plan

Aimantation
dans le plan à $V=V_{max}$

32

**Fig. 3a**

$K_{eff} \cdot t_F$

$K_{S1}+K_{S2}(V=V_{max})$

$K_{S1}+K_{S2}(V=0)$

34

Aimantation
hors du plan à $V=V_{max}$

Hors du plan

0     $t_F$

$t_C$

Dans le plan

Aimantation
dans le plan à V=0

33

**Fig. 3b**

Réorientation de l'aimantation
contrôlée en tension

Hors du plan
quel que soit V

Dans le plan
quel que soit V

$\Delta T$

surf(V=0)

surf(V$_{max}$)

$K*t_F$ (u.a.)

vol

eff(V=0)

eff(V$_{max}$)

RT
Temperature

$T_{cF}$

**Fig. 4**

10

4

3

2-1 ⎫
       ⎬ 2
2-2 ⎭

1

**Fig. 5**

Hors du plan
quel que soit V

Réorientation de
l'aimantation
contrôlée en tension

Hors du plan
quel que soit V

surf(V_max)

surf(V=0)

vol

62

K*t_F (u.a.)

61

60

eff(V=0)

eff(V_max)

RT
Temperature

**Fig. 6**

Hors du plan
quel que soit V

Réorientation de
l'aimantation
contrôlée en tension

Dans le plan
quel que soit V

surf(V_max)

surf(V=0)

vol

72

K*t_F (u.a.)

71

70

eff(V=0)

eff(V_max)

RT
Temperature

**Fig. 7**

**Fig. 8**

Dans le plan quel que soit V

Réorientation de l'aimantation contrôlée en tension

Dans le plan quel que soit V

$K*t_F$ (u.a.)

surf($V_{max}$)

surf(V=0)

vol

80

81

82

eff(V=0)

eff($V_{max}$)

RT
Temperature

**Fig. 9**

Dans le plan quel que soit V

Réorientation de l'aimantation contrôlée en tension

Hors du plan quel que soit V

$K*t_F$ (u.a.)

surf(V=0)

surf($V_{max}$)

vol

90

91

92

eff(V=0)

eff($V_{max}$)

RT
Temperature

Fig. 10

Fig. 11

**Fig. 12**

**Fig. 13**

Fig. 14

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20130175646 A

**Littérature non-brevet citée dans la description**

- **TAKAYUKI KAWAHARA.** Challenges toward giga-bit-scale spin-transfer torque random access memory and beyond for normally off, green information technology infrastructure. *J. Appl. Phys.,* 2011, vol. 109, 07D325
- **YOICHI SHIOTA et al.** Induction of coherent magnetization switching in a few atomic layers of FeCo using voltage pulse. *Nature materials,* 2012, vol. 11 (39
- **YANG et al.** First-principles investigation of the very large perpendicular magnetic anisotropy at Fe/MgO and Co/MgO interfaces. *Physical Review B,* 2011, vol. 84, 054401

- **S. MONSO et al.** Crossover from in-plane to perpendicular anisotropy in Pt/CoFe/AlOx as a function of the Al degree of oxidation : a very accurate control of the oxydation of tunnel barrier. *Appl. Phys. Lett.,* 2002, vol. 80, 4157
- **A. MANCHON et al.** Analysis of oxygen induced anisotropy crossover in Pt/Co/MOx trilayers. *J. Appl. Phys.,* 2008, vol. 104, 043914
- **YANG H.X. et al.** First-principles investigation of the very large perpendicular magnetic anisotropy at Fe/MgO and Co/MgO interfaces. *Phys. Rev. B,* 2011, vol. 84, 054401
- **G. SRINIVAS et al.** Magnetic and magneto-optical properties of (Pt/Co/Pt/Ni) multilayers. *Thin Solid Films,* 1997, vol. 301, 211-216